# EUROPEAN PATENT APPLICATION

(11) **EP 4 478 611 A1**
(43) Date of publication of application: **18.12.2024**
(21) Application number: 24765314.0
(22) Date of filing: 21.02.2024
(51) Int. Cl.: H03H 9/64

(54) **ACOUSTIC FILTER AND PREPARATION METHOD THEREFOR, AND ELECTRONIC DEVICE**

(30) Priority: 24.03.2023 CN 202310351296; 31.05.2023 CN 202310643636
(71) Applicant: HUAWEI TECHNOLOGIES CO., LTD., Shenzhen, Guangdong 518129 (CN)
(72) Inventor: KE, Han, Shenzhen Guangdong 518129 (CN); TANG, Daiping, Shenzhen Guangdong 518129 (CN); TAO, Xiang, Shenzhen Guangdong 518129 (CN)
(74) Representative: Pfenning, Meinig & Partner mbB
(86) International application number: PCT/CN2024/077858
(87) International publication number: WO 2024/198776

(57) **Abstract**

Embodiments of this application provide an acoustic filter, a production method therefor, and an electronic device, to relieve impact of a transverse mode excited in an acoustic resonator. The acoustic filter includes a piezoelectric substrate and an interdigital transducer located on a side of the piezoelectric substrate. The interdigital transducer includes a first bus bar and a second bus bar. An edge region, a gap region, a central region, and a slant region that are arranged in a first direction are included between the first bus bar and the second bus bar. Parts that are of a first electrode finger and that are located in the edge region, the gap region, and the central region are parallel to the first direction, and a part that is of the first electrode finger and that is located in the slant region is slanted relative to both the first direction and a second direction. A sound speed of an excited surface acoustic wave at the part that is of the first electrode finger and that is located in the slant region is reduced, so that the part forms a waveguide, to adjust charge distribution of an interdigital electrode and suppress excitation of the transverse mode. Based on the foregoing disposal, only extension directions of parts of the first electrode fingers need to be adjusted. This helps reduce an area occupied by a resonator.

## Description

This application claims priorities to Chinese Patent Application No. 202310351296.0, filed with the China National Intellectual Property Administration on March 24, 2023 and entitled "ACOUSTIC FILTER, PRODUCTION METHOD THEREFOR, AND ELECTRONIC DEVICE", and to Chinese Patent Application No. 202310643636.7, filed with the China National Intellectual Property Administration on May 31, 2023 and entitled "ACOUSTIC FILTER, PRODUCTION METHOD THEREFOR, AND ELECTRONIC DEVICE", both of which are incorporated herein by reference in their entireties.

### TECHNICAL FIELD

Embodiments of this application relate to the field of signal processing technologies, and in particular, to an acoustic filter, a production method therefor, and an electronic device.

### BACKGROUND

A surface acoustic wave resonator includes a piezoelectric substrate and an interdigital transducer. The interdigital transducer is located on a side of the piezoelectric substrate. The interdigital transducer includes a bus bar and an interdigital electrode. A piezoelectric material in the piezoelectric substrate has a piezoelectric effect, to implement mutual conversion between an electrical signal and an acoustic wave. A surface acoustic wave is excited through interaction between the interdigital electrode and the piezoelectric material, and a radio frequency acoustic filter may be constructed by using a resonance characteristic of the surface acoustic wave.

However, the surface acoustic wave forms a transverse standing wave, namely, a transverse mode, between bus bars. A spurious mode caused by the transverse mode affects passband flatness of the acoustic filter and increases an insertion loss of the acoustic filter.

### SUMMARY

An objective of embodiments of this application is to provide an acoustic filter, a production method therefor, and an electronic device, to relieve impact of a transverse mode excited in the acoustic filter.

To achieve the foregoing objective, embodiments of this application provide the following solutions.

In one aspect, an acoustic filter is provided. The acoustic filter includes a piezoelectric substrate and an interdigital transducer located on a side of the piezoelectric substrate. The interdigital transducer includes a first bus bar and a second bus bar, the first bus bar and the second bus bar are disposed opposite to each other in a first direction, and the first direction is parallel to the piezoelectric substrate. The interdigital transducer further includes an interdigital electrode, and the interdigital electrode includes a plurality of first electrode fingers and a plurality of second electrode fingers. A first electrode finger and a second electrode finger are oppositely disposed at an interval in the first direction, one of the first electrode finger and the second electrode finger is connected to the first bus bar, and the other is connected to the second bus bar. The first electrode fingers and the second electrode fingers are alternately disposed at intervals in a second direction, the second direction is parallel to the piezoelectric substrate, and the second direction is perpendicular to the first direction. Based on the foregoing disposal, the first bus bar can be connected to both the first electrode fingers and the second electrode fingers, and the second bus bar can be connected to both the first electrode fingers and the second electrode fingers. In this way, the first bus bar and the second bus bar can provide a voltage to the first electrode fingers and the second electrode fingers, and the first electrode fingers and the second electrode fingers can excite a surface acoustic wave.

Based on the foregoing disposal, an edge region, a gap region, a central region, and a slant region that are arranged in the first direction are included between the first bus bar and the second bus bar, the slant region is located between the central region and the gap region, and the gap region is located between the slant region and the edge region. The second electrode fingers are located in the edge region. Parts that are of the first electrode finger and that are located in the edge region, the gap region, and the central region are parallel to the first direction, and a part that is of the first electrode finger and that is located in the slant region is slanted relative to both the first direction and the second direction. Based on a slowness characteristic of the acoustic wave filter, there is a specific correlation between extension directions of the electrode fingers in the acoustic wave filter and a sound speed of a surface acoustic wave excited by the electrode fingers. The slant region is disposed. In this way, the sound speed of the excited surface acoustic wave at the part that is of the first electrode finger and that is located in the slant region is reduced, so that the part can form a waveguide, to adjust charge distribution of the interdigital electrode in the second direction and further suppress excitation of a transverse mode. Compared with that in adjustment of a shape of an overall structure of an interdigital transducer, excitation of the transverse mode in embodiments of this application is suppressed by disposing the slant region. Only extension directions of parts of the first electrode fingers need to be adjusted. This helps reduce an area occupied by a resonator.

Based on the foregoing disposal, in any one of the first electrode finger and the second electrode finger that are oppositely disposed at an interval in the first direction, the part that is of the first electrode finger and that is located in the central region is located on a first side of the opposite second electrode finger. Based on the foregoing disposal, in a same slant region, extension directions of parts that are of first electrode fingers and that are located in the slant region are the same. This facilitates reduction of difficulty in producing the acoustic filter. In addition, because inclination angles of the parts located in the slant region are related to the slowness characteristic of the acoustic wave filter, the first electrode fingers located in the same slant region have a same suppression effect on the transverse mode.

In some embodiments, a transition region is further included between the first bus bar and the second bus bar, the transition region is bordered between the slant region and the gap region, and a part that is of the first electrode finger and that is located in the transition region is parallel to the first direction. The transition region is disposed. This helps avoid a sudden change of the sound speed between the slant region and the gap region, thereby avoiding generation of effects such as bulk acoustic wave scattering, and further avoiding generation of another spurious mode.

In some embodiments, a length of a part that is of the interdigital electrode and that is located in the edge region ranges from 0.1λ to 3λ, and a length of a part that is of the interdigital electrode and that is located in the transition region ranges from 0.1λ to 1λ, where λ is a period length of the interdigital electrode. Based on the foregoing disposal, the interdigital transducer provided in embodiments of this application can further suppress excitation of a higher-order transverse mode.

In some embodiments, a width of the part that is of the first electrode finger and that is located in the slant region is greater than or equal to a width of the part that is of the first electrode finger and that is located in the central region. For example, an edge that is of the first electrode finger and that is located in the slant region includes a first edge and a second edge that are disposed opposite to each other. The "width" is a distance between the first edge and the second edge. Because a material of the first electrode finger generally includes metal, when the width of the part that is of the first electrode finger and that is located in the slant region is greater than the width of the part that is of the first electrode finger and that is located in the central region, a metallization ratio of the first electrode finger located in the slant region is increased. This helps further reduce a sound speed corresponding to the slant region, thereby suppressing excitation of the transverse mode.

In some embodiments, the edge region includes a first edge region and a second edge region that are disposed opposite to each other in the first direction, the gap region includes a first gap region and a second gap region that are disposed opposite to each other in the first direction, and the slant region includes a first slant region and a second slant region that are disposed opposite to each other in the first direction. The first gap region is located between the first edge region and the first slant region, and the second gap region is located between the second edge region and the second slant region. The first slant region and the second slant region are disposed. In this way, a speed of an excited sound at parts that are of the first interdigital electrode and that are located in the first slant region and the second slant region is reduced, so that the parts that are of the first interdigital electrode and that are located in the first slant region and the second slant region can form a waveguide, to further adjust charge distribution of the interdigital electrode in the second direction and suppress excitation of the transverse mode.

In some embodiments, the first slant region includes a first boundary line and a second boundary line that are disposed opposite to each other in the first direction, and there is a first preset included angle between the second direction and a normal of a connection line between a midpoint of the first electrode finger on the first boundary line and a midpoint of the first electrode finger on the second boundary line. Based on the foregoing disposal, the part that is of the first electrode finger and that is located in the first slant region is slanted relative to both the first direction and the second direction. The second slant region includes a third boundary line and a fourth boundary line that are disposed opposite to each other in the first direction, and there is a second preset included angle between the second direction and a normal of a connection line between a midpoint of the first electrode finger on the third boundary line and a midpoint of the first electrode finger on the fourth boundary line. Based on the foregoing disposal, the part that is of the first electrode finger and that is located in the second slant region is slanted relative to both the first direction and the second direction.

In some embodiments, the first preset included angle ranges from 3° to 20°, and based on the foregoing disposal, the part that is of the first electrode finger and that is located in the first slant region can form a waveguide to suppress excitation of the transverse mode; and/or the second preset included angle ranges from -3° to -20°, and based on the foregoing disposal, the part that is of the first electrode finger and that is located in the second slant region can form a waveguide to suppress excitation of the transverse mode. Further, for an acoustic wave filter having a symmetric slowness characteristic, absolute values of the first preset included angle and the second preset included angle may be the same.

In some embodiments, the edge that is of the first electrode finger and that is located in the slant region includes a straight line segment, and/or the edge of the first electrode finger located in the slant region includes an arc line segment.

In some embodiments, the acoustic filter further includes a load portion. The load portion is located in the slant region, and is located on a side that is of the first electrode finger and that is away from the piezoelectric substrate. The load portion is disposed. This helps increase mass load of the first electrode finger in the slant region and further reduce the sound speed corresponding to the slant region, thereby suppressing generation of the transverse mode.

In some embodiments, the load portion includes a conducting layer, and an orthographic projection of the conducting layer on the piezoelectric substrate is located within an orthographic projection of the first electrode finger on the piezoelectric substrate. For example, there may be a plurality of conducting layers, and one conducting layer corresponds to one part that is of the first electrode finger and that is located in the slant region. An orthographic projection of the conducting layer on the piezoelectric substrate is located within an orthographic projection of a first electrode finger corresponding to the conducting layer on the piezoelectric substrate. In this way, the plurality of conducting layers are electrically isolated from each other. This avoids a short circuit between adjacent first electrode fingers.

In some embodiments, the load portion includes a dielectric layer. The dielectric layer is parallel to the second direction, and at least a part that is of the first electrode finger and that is located in the slant region overlaps the dielectric layer. For example, the dielectric layer may be of a long-strip structure extending in the second direction. Because the dielectric layer does not have a conductive property, adjacent first electrode fingers are electrically isolated from each other. This avoids a short circuit between adjacent first electrode fingers. In addition, the dielectric layer is of a continuous structure extending in the second direction. This helps reduce difficulty in manufacturing the dielectric layer.

In some embodiments, each of the first bus bar and the second bus bar includes a first convergence region, a grid region, and a second convergence region that are arranged in the first direction, and the grid region is located between the first convergence region and the second convergence region; and a part that is of the bus bar and that is located in the grid region includes a plurality of grids disposed at intervals in the second direction. The grid region is disposed in the bus bar. In this way, a new degree of freedom can be introduced into the grid region of the bus bar, to adjust sound speed distribution corresponding to the bus bar. In addition, the grid region is disposed in the bus bar, so that charge distribution of the bus bar can be further changed, to further change electric field distribution of the bus bar. By changing the electric field distribution of the bus bar and the corresponding sound speed distribution, an excitation condition of an inclination transverse mode can be weakened, and therefore the inclination transverse mode can be suppressed.

In some embodiments, center lines of the grids of the first bus bar are first center lines, center lines of the grids of the second bus bar are second center lines, and the first center lines and the second center lines all extend in the first direction. A center line of a part that is of a first electrode finger or a second electrode finger bordering the first bus bar and that is located in the edge region coincides with one first center line. A center line of a part that is of a first electrode finger or a second electrode finger bordering the second bus bar and that is located in the edge region coincides with one second center line. The foregoing disposal helps improve normalization of the interdigital transducer, further changes the electric field distribution and the corresponding sound speed distribution of the bus bar, and further weakens the excitation condition of the inclination transverse mode, thereby suppressing the inclination transverse mode.

In some embodiments, center lines of the grids of the first bus bar are first center lines, center lines of the grids of the second bus bar are second center lines, and the first center lines and the second center lines all extend in the first direction. Center lines of the grids of the first bus bar are first center lines, center lines of the grids of the second bus bar are second center lines, and the first center lines and the second center lines all extend in the first direction. A first electrode finger and a second electrode finger that are adjacent in the second direction are located on two sides of one first center line, and a distance between the first electrode finger and the center line is equal to a distance between the second electrode finger and the center line. The foregoing disposal helps improve normalization of the interdigital transducer, further changes the electric field distribution and the corresponding sound speed distribution of the bus bar, and further weakens the excitation condition of the inclination transverse mode, thereby suppressing the inclination transverse mode.

In some embodiments, the grids of the first bus bar and the grids of the second bus bar are symmetrically disposed. The foregoing disposal helps improve normalization of the interdigital transducer, further changes the electric field distribution and the corresponding sound speed distribution of the bus bar, and further weakens the excitation condition of the inclination transverse mode, thereby suppressing the inclination transverse mode.

In some embodiments, the grids of the first bus bar and the grids of the second bus bar are disposed in a staggered manner in the first direction. The foregoing disposal helps improve normalization of the interdigital transducer, further changes the electric field distribution and the corresponding sound speed distribution of the bus bar, and further weakens the excitation condition of the inclination transverse mode, thereby suppressing the inclination transverse mode.

In another aspect, an embodiment of this application further provides a production method for an acoustic filter, including providing a piezoelectric substrate and forming an interdigital transducer. The interdigital transducer is located on a side of the piezoelectric substrate. In the piezoelectric substrate and the interdigital transducer located on the side of the piezoelectric substrate, the interdigital transducer includes a first bus bar and a second bus bar. The first bus bar and the second bus bar are disposed opposite to each other in a first direction. The first direction is parallel to the piezoelectric substrate. The interdigital transducer further includes an interdigital electrode, and the interdigital electrode includes a plurality of first electrode fingers and a plurality of second electrode fingers. A first electrode finger and a second electrode finger are oppositely disposed at an interval in the first direction, one of the first electrode finger and the second electrode finger is connected to the first bus bar, and the other is connected to the second bus bar. The first electrode fingers and the second electrode fingers are alternately disposed at intervals in a second direction, the second direction is parallel to the piezoelectric substrate, and the second direction is perpendicular to the first direction. An edge region, a gap region, a central region, and a slant region that are arranged in the first direction are included between the first bus bar and the second bus bar, the slant region is located between the central region and the gap region, and the gap region is located between the slant region and the edge region. The second electrode fingers are located in the edge region. Parts that are of the first electrode finger and that are located in the edge region, the gap region, and the central region are parallel to the first direction, and a part that is of the first electrode finger and that is located in the slant region is slanted relative to both the first direction and the second direction. In any one of the first electrode finger and the second electrode finger that are oppositely disposed at an interval in the first direction, the part that is of the first electrode finger and that is located in the central region is located on a first side of the opposite second electrode finger. The acoustic filter formed according to the production method for the acoustic filter provided in this embodiment of this application includes the foregoing acoustic filter, and therefore has all the foregoing beneficial effects. Details are not described herein again.

In another aspect, an embodiment of this application further provides an electronic device, including the acoustic filter in any one of the foregoing embodiments. The electronic device provided in this embodiment of this application includes the foregoing acoustic filter, and therefore has all the foregoing beneficial effects. Details are not described herein again.

### BRIEF DESCRIPTION OF DRAWINGS

FIG. 1 is a diagram of a structure of an electronic device according to an embodiment of this application;
FIG. 2 is a block diagram of an acoustic filter according to an embodiment of this application;
FIG. 3 is a diagram of a structure of a resonator according to an embodiment of this application;
FIG. 4 is a diagram of a structure of an interdigital transducer according to an embodiment of this application;
FIG. 5 is a diagram of a structure of an interdigital transducer in a resonator according to some embodiments of this application;
FIG. 6 is a top view of the resonator in FIG. 5;
FIG. 7 is a diagram of a structure of an interdigital transducer in another resonator according to some embodiments of this application;
FIG. 8 is a diagram of a slowness curve of a piezoelectric substrate in an interdigital transducer according to an embodiment of this application;
FIG. 9 is a diagram of amplitude curves, in a frequency range in a transverse mode, of the interdigital transducer in FIG. 4 and an interdigital transducer provided with no slant region;
FIG. 10 is a diagram of conductivity curves of the interdigital transducer in FIG. 4 and an interdigital transducer provided with no slant region;
FIG. 11 is a diagram of a structure of another interdigital transducer according to an embodiment of this application;
FIG. 12 is a diagram of a sound speed curve corresponding to the interdigital transducer in FIG. 11;
FIG. 13 is a diagram of conductivity curves of the interdigital transducer in FIG. 4, the interdigital transducer in FIG. 11, and an interdigital transducer provided with no slant region;
FIG. 14 is a diagram of a structure of another interdigital transducer according to an embodiment of this application;
FIG. 15 is a partially enlarged diagram of a part that is of a first electrode finger in FIG. 14 and that is located in a slant region;
FIG. 16 is a diagram of a structure of another interdigital transducer according to an embodiment of this application;
FIG. 17 is a diagram of a structure of another interdigital transducer according to an embodiment of this application;
FIG. 18 is a diagram of a structure of another interdigital transducer according to an embodiment of this application;
FIG. 19 is a diagram of a structure of another interdigital transducer according to an embodiment of this application;
FIG. 20 is a diagram of conductivity curves of an interdigital transducer provided with a slant region and a grid region, an interdigital transducer provided with only a slant region, and an interdigital transducer provided with no slant region;
FIG. 21 is a diagram of a structure of another interdigital transducer according to an embodiment of this application;
FIG. 22 is a diagram of speed distribution of a piezoelectric substrate in the interdigital transducer in FIG. 21 in a first direction Y;
FIG. 23 is a diagram of a structure of another interdigital transducer according to an embodiment of this application;
FIG. 24 is a diagram of a structure of another interdigital transducer according to an embodiment of this application;
FIG. 25 is a diagram of a structure of another interdigital transducer according to an embodiment of this application;
FIG. 26 is a diagram of a structure of another interdigital transducer according to an embodiment of this application;
FIG. 27 is a diagram of a structure of another interdigital transducer according to an embodiment of this application;
FIG. 28 is a diagram of conductivity curves of the interdigital transducer in FIG. 23, the interdigital transducer in FIG. 24, the interdigital transducer in FIG. 25, the interdigital transducer in FIG. 26, and the interdigital transducer in FIG. 27;
FIG. 29 is a diagram of a structure of another interdigital transducer according to an embodiment of this application; and
FIG. 30 is a flowchart of steps of a production method for another acoustic filter according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms such as "first" and "second" mentioned below are merely intended for ease of description, and shall not be understood as an indication or implication of relative importance or implicit indication of a quantity of indicated technical features. Therefore, a feature defined by "first" or "second" may explicitly or implicitly include one or more features. In the descriptions of this application, unless otherwise stated, "a plurality of" means two or more than two.

In addition, in embodiments of this application, the word "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a relative concept in a specific manner.

In embodiments of this application, for example, on, under, left, right, front, and rear are relative direction indications used to explain structures and movement of different parts in this application. These indications are appropriate when the parts are at locations shown in the figure. However, if descriptions of the locations of the parts change, these direction indications correspondingly change.

In embodiments of this application, "parallel", "perpendicular to", "equal to", and "overlapping" include described cases and similar cases. A range of a similar case is in an acceptable deviation range. The acceptable deviation range is determined by a person of ordinary skill in the art by considering an error (namely, a limitation of a measurement system) related to measurement being discussed and measurement of a specific quantity.

For example, "parallel" includes "absolutely parallel" and "approximately parallel", and an acceptable deviation range of "approximately parallel" may be, for example, a deviation within 5°. "Perpendicular to" includes "absolutely perpendicular to" and "approximately perpendicular to", and an acceptable deviation range of "approximately perpendicular to" may also be, for example, a deviation within 5°. "Equal to" includes "absolutely equal to" and "approximately equal to". An acceptable deviation range of "approximately equal to" may be that, for example, a difference between two equal objects is less than or equal to 5% of either of the two objects. "Coincidence" includes "absolute coincidence" and "approximate coincidence". An acceptable deviation range of "approximate coincidence" may be that, for example, a difference between two coincided objects is less than or equal to 5% of either of the two objects.

It should be understood that, when a layer or an element is referred to as on another layer or substrate, the layer or element may be directly on the another layer or substrate, or an intermediate layer may exist between the layer or element and the another layer or substrate.

In embodiments of this application, example implementations are described with reference to sectional views and/or plane diagrams that are used as idealized example accompanying drawings. In the accompanying drawings, for clarity, thicknesses of layers and regions are increased. Therefore, a change of a shape in the accompanying drawings due to, for example, a manufacturing technique and/or tolerance may be envisaged. Therefore, example implementations should not be construed as being limited to shapes of regions shown herein, but rather include shape deviations due to, for example, manufacturing. For example, an etching region shown as a rectangle typically has a bending characteristic. Therefore, the regions shown in the accompanying drawings are essentially examples, and their shapes are not intended to show actual shapes of regions of a device, and are not intended to limit a scope of the example implementations.

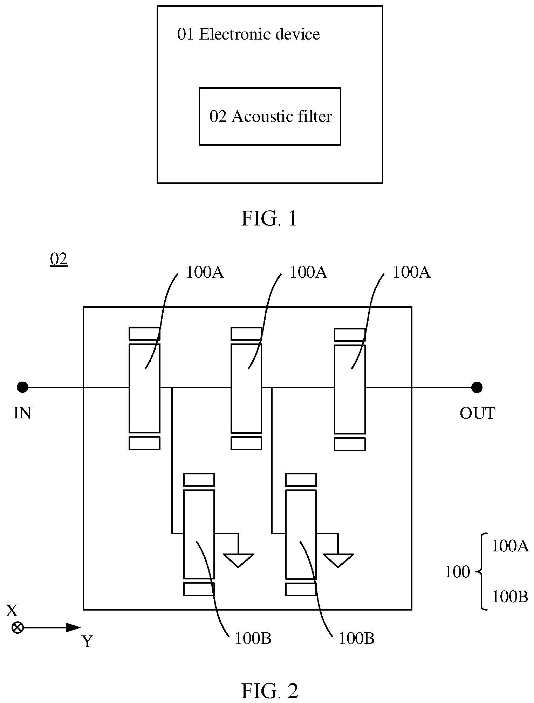

FIG. 1 is a diagram of a structure of an electronic device 01 according to an embodiment of this application. The electronic device 01 provided in this application includes an acoustic filter 02, and the acoustic filter 02 may be an acoustic filter 02 in any one of the following embodiments. The acoustic filter 02 may be the following types: One type of the acoustic filter 02 may include an acoustic resonator, another type of the acoustic filter 02 may include a longitudinally coupled resonance unit (coupling resonance filter, CRF), and another type of the acoustic filter 02 includes both an acoustic resonator and a longitudinally coupled resonance unit. There may be a plurality of acoustic filters 02, and the plurality of acoustic filters 02 may form a multiplexer.

The electronic device 01 may be an intermediate product, for example, a radio frequency front-end or a filter and amplification module, or the electronic device 01 may be a terminal product, for example, a mobile phone, a tablet computer, or an uncrewed aerial vehicle.

FIG. 2 is a block diagram of an acoustic filter 02 according to an embodiment of this application. As shown in FIG. 2, the acoustic filter 02 may include at least one first component 100A and at least one second component 100B. The acoustic filter 02 may further include an input terminal IN, an output terminal OUT, and a ground terminal. The at least one first component 100A may be electrically connected in series between the input terminal IN and the output terminal OUT, and the second component 100B may be electrically connected between the first component 100A and the ground terminal. A plurality of first components 100A are disposed, so that the acoustic filter 02 forms a first band stop. A plurality of second components 100B are disposed, so that the acoustic filter 02 forms a second band stop. Based on the foregoing disposal, the acoustic filter 02 has corresponding bandpass, to enable pass-through of a signal in a corresponding frequency band.

For example, the acoustic filter 02 shown in FIG. 2 may include three first components 100A and two second components 100B. Certainly, in another embodiment, a quantity of the first components 100A and a quantity of the second components 100B in the acoustic filter 02 may be correspondingly set based on an actual requirement.

Both the first component 100A and the second component 100B may be a resonator 100. The resonator 100 may be of a structure in any one of the following embodiments.

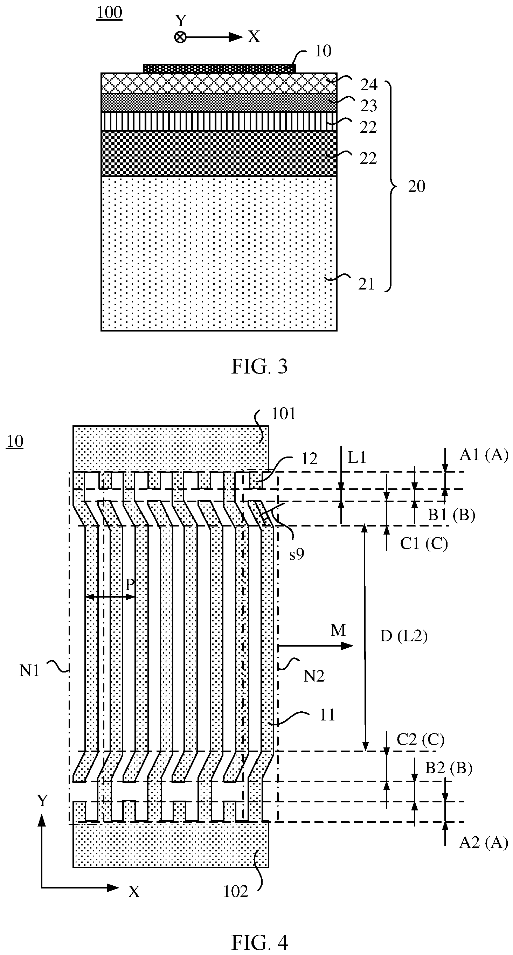

FIG. 3 is a diagram of a structure of a resonator 100 according to an embodiment of this application. As shown in FIG. 3, the resonator 100 includes a piezoelectric substrate 20 and an interdigital transducer 10 located on a side of the piezoelectric substrate 20.

The piezoelectric substrate 20 includes a high-sound-speed layer 21, a low-sound-speed layer 23, and a piezoelectric layer 24 that are sequentially disposed in a laminated manner. A material of the piezoelectric layer 24 may include one or a combination of a plurality of materials of lithium niobate, lithium tantalate, quartz, gallium arsenide, ceramic, or lithium tetraborate. This is not limited in this application. A sound speed at the low-sound-speed layer 23 is lower than a sound speed at the high-sound-speed layer 21. For example, a material of the low-sound-speed layer 23 may include one or a combination of a plurality of materials of silicon dioxide, titanium oxide, germanium oxide, or silicon oxynitride. A material of the high-sound-speed layer 21 may include one or a combination of a plurality of materials of silicon, diamond, sapphire, silicon carbide, silicon nitride, aluminum oxide, quartz, or aluminum nitride. This is not limited in this application.

In some other embodiments, the piezoelectric substrate 20 may further include a functional layer 22, and the functional layer 22 may be located between the low-sound-speed layer 23 and the high-sound-speed layer 21. The functional layer 22 is disposed. This helps improve overall performance of the substrate, for example, improve a quality factor of the resonator. There may be one or more functional layers 22.

Still with reference to FIG. 3, for example, the interdigital transducer 10 may be located on a side that is of the piezoelectric layer 24 and that is away from the low-sound-speed layer 23. A material of the interdigital transducer 10 may include one or a combination of a plurality of materials of aluminum, copper, titanium, gold, silver, platinum, and molybdenum, or a material of the interdigital transducer 10 may be another alloy material.

FIG. 4 is a diagram of a structure of an interdigital transducer 10 according to an embodiment of this application. A first direction Y and a second direction X in the following are both parallel to a piezoelectric substrate 20, and the first direction Y is perpendicular to the second direction X.

As shown in FIG. 4, the interdigital transducer 10 includes a first bus bar 101 and a second bus bar 102. The first bus bar 101 and the second bus bar 102 are disposed opposite to each other in the first direction Y. For example, the first bus bar 101 may be located at the upper end in FIG. 4. The first bus bar 101 may be approximately a rectangle, and the first bus bar 101 may be parallel to the second direction X. The second bus bar 102 may be located at the lower end in FIG. 4. The second bus bar 102 may be approximately a rectangle, and the second bus bar 102 may be parallel to the second direction X.

The interdigital transducer 10 further includes an interdigital electrode, and the interdigital electrode includes a plurality of first electrode fingers 11 and a plurality of second electrode fingers 12. For example, a length of the first electrode finger 11 may be greater than a length of the second electrode finger 12.

The first electrode finger 11 and the second electrode finger 12 are oppositely disposed at an interval in the first direction Y, one of the first electrode finger 11 and the second electrode finger 12 is connected to the first bus bar 101, and the other is connected to the second bus bar 102. For example, the first electrode finger 11 and the second electrode finger 12 that are oppositely disposed at an interval in the first direction Y are referred to as an electrode finger group. In an electrode finger group at a place N1 in FIG. 4, an end that is of a first electrode finger 11 and that is away from a second electrode finger 12 is connected to the first bus bar 101, and an end that is of the second electrode finger 12 and that is away from the first electrode finger 11 is connected to the second bus bar 102. In an electrode finger group at a place N2 in FIG. 4, in a first electrode finger 11 and a second electrode finger 12 that are disposed opposite to each other in the first direction Y, an end that is of the first electrode finger 11 and that is away from the second electrode finger 12 is connected to the second bus bar 102, and an end that is of the second electrode finger 12 and that is away from the first electrode finger 11 is connected to the first bus bar 101.

The first electrode fingers 11 and the second electrode fingers 12 are alternately disposed at intervals in the second direction X. For example, first electrode fingers 11 and second electrode fingers 12 that are connected to the first bus bar 101 are alternately disposed at intervals in the second direction X, and first electrode fingers 11 and second electrode fingers 12 that are connected to the second bus bar 102 are also alternately disposed at intervals in the second direction X.

Based on the foregoing disposal, the first bus bar 101 can be connected to both the first electrode fingers 11 and the second electrode fingers 12, and the second bus bar 102 can be connected to both the first electrode fingers 11 and the second electrode fingers 12. In this way, the first bus bar 101 and the second bus bar 102 can provide electrical excitation to the first electrode fingers 11 and the second electrode fingers 12, and the first electrode fingers 11 and the second electrode fingers 12 can excite a surface acoustic wave. A main propagation direction M of the surface acoustic wave is the second direction X. A component that is of the surface acoustic wave and that is perpendicular to the main propagation direction M forms a standing wave, namely, a transverse mode, between the first bus bar 101 and the second bus bar 102. The transverse mode is reflected by an electrical response of a resonator 100, and a spurious mode is generated near a resonance frequency and an anti-resonance frequency. The spurious mode affects flatness of a passband, and increases an insertion loss of the acoustic filter.

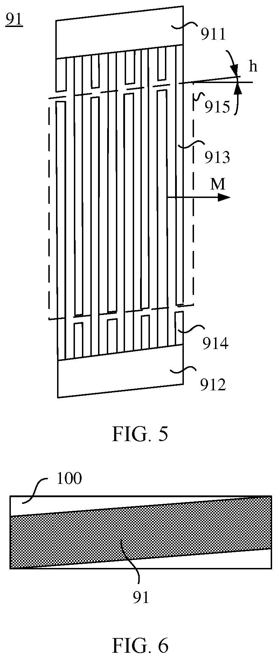

FIG. 5 is a diagram of a structure of an interdigital transducer 91 in a resonator according to some embodiments of this application. As shown in FIG. 5, the interdigital transducer 91 includes a first bus bar 911, a second bus bar 912, first electrode fingers 913, and second electrode fingers 914. Different from that in the structure in embodiments of this application, an included angle exists between each of the first bus bar 911 and the second bus bar 912, and a main propagation direction M. An overlapping part of the first electrode fingers 913 forms an acoustic wave propagation channel 915. An included angle between the acoustic wave propagation channel 915 and the main propagation direction M is a preset included angle h. FIG. 6 is a top view of the resonator in FIG. 5. However, with reference to FIG. 5 and FIG. 6, it can be learned that, because the foregoing structure is approximately a parallelogram integrally, an area occupied by the interdigital transducer 91 in an acoustic filter is large. As a result, space utilization of the acoustic filter is reduced.

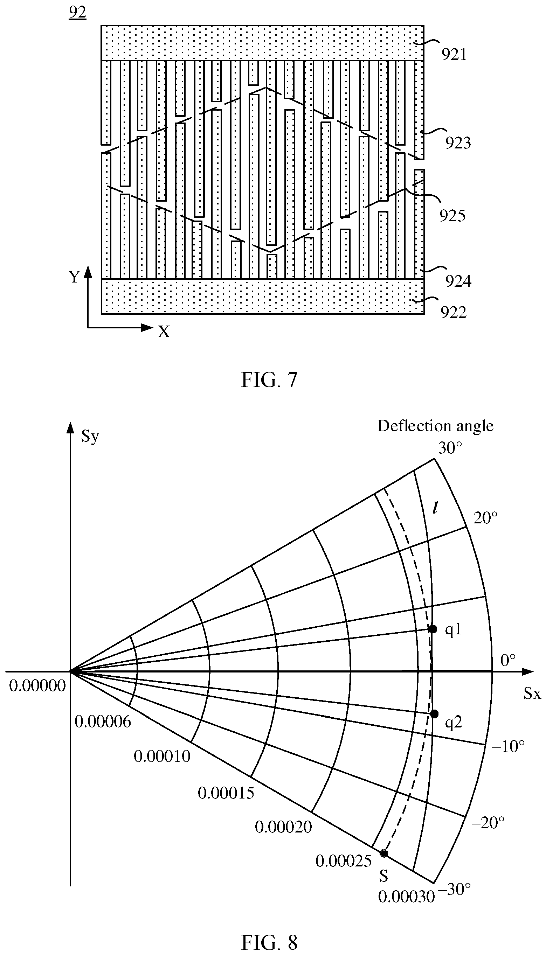

FIG. 7 is a diagram of a structure of an interdigital transducer 92 in another resonator according to some embodiments of this application. As shown in FIG. 7, the interdigital transducer 92 includes a first bus bar 921, a second bus bar 922, first electrode fingers 923, and second electrode fingers 924. Different from that in the structure in embodiments of this application, an overlapping part of the first electrode fingers 923 in a second direction X forms an acoustic wave propagation channel 925. A length of the acoustic wave propagation channel 925 in a first direction Y is an aperture length, and the aperture length gradually changes in the second direction X. However, to increase the aperture length, an area of an overall structure of the resonator is increased. As a result, an area occupied by the resonator in an acoustic filter is large, and then space utilization of the acoustic filter is reduced.

In view of this, still with reference to FIG. 4, in embodiments of this application, an edge region A, a gap region B, a central region D, and a slant region C that are arranged in the first direction Y are included between the first bus bar 101 and the second bus bar 102. As shown in FIG. 4, the second electrode fingers 12 are located in the edge region A, and the first electrode fingers 11 are located in the edge region A, the gap region B, the central region D, and the slant region C.

For example, in the edge region A, the first electrode fingers 11 and the second electrode fingers 12 overlap each other in the second direction X. In some embodiments, the edge region A may include a first edge region A1 and a second edge region A2 that are disposed opposite to each other in the first direction Y. The first edge region A1 may border the first bus bar 101. In the first edge region A1, the second electrode fingers 12 connected to the first bus bar 101 overlap each other in the second direction X. The second edge region A2 may border the second bus bar 102. In the second edge region A2, the second electrode fingers 12 connected to the second bus bar 102 overlap each other in the second direction X.

For example, in the gap region B, the first electrode fingers 11 overlap each other in the second direction X. In some embodiments, the gap region B may include a first gap region B1 and a second gap region B2. The first gap region B1 borders a side that is of the first edge region A1 and that is away from the first bus bar 101. In the first gap region B1, the first electrode fingers 11 connected to the first bus bar 101 overlap each other in the second direction X. The second gap region B2 borders a side that is of the second edge region A2 and that is away from the second bus bar 102. In the second gap region B2, the first electrode fingers 11 connected to the second bus bar 102 overlap each other in the second direction X.

A length L1 of a part that is of the first electrode finger 11 and that is located in the gap region B may range from 0.05λ, to 0.3λ. Herein, λ, is a period length P of the interdigital electrode. Herein, the period length P is a distance between two adjacent first interdigital electrodes that are connected to the first bus bar 101. For example, a length L1 of a part that is of a first electrode finger 11 and that is located in the first gap region B1 may be 0.05λ, 0.175λ, or 0.3λ, and a length L1 of a part that is of the first electrode finger 11 and that is located in the second gap region B2 may also be 0.05λ, 0.175λ, or 0.3λ. When the length L1 of the part that is of the first electrode finger 11 and that is located in the gap region B approaches 0.05λ, it is helpful to avoid a sudden change of sound impedance in the first direction Y, thereby avoiding generation of effects such as bulk acoustic wave scattering, and further avoiding generation of another spurious mode.

For example, in the central region D and the slant region C, the first electrode fingers 11 overlap each other in the second direction X. The slant region C is located between the central region D and the gap region B. The gap region B is located between the slant region C and the edge region A. Based on the foregoing disposal, the central region D and the slant region C are located between the first gap region B1 and the second gap region B2. A length L2 of a part that is of the first electrode finger 11 and that is located in the central region D may range from 10λ to 50λ. Herein, λ is the period length P of the interdigital electrode. Herein, the period length P is the distance between the two adjacent first interdigital electrodes that are connected to the first bus bar 101. For example, a length L2 of a part that is of the first electrode finger 11 and that is located in the central region D may be 10k, 30k, or 50λ.

In some embodiments, there may be one slant region C. The slant region C may be located between the first gap region B1 and the central region D, or the slant region C may be located between the second gap region B2 and the central region D. In some other embodiments, there may be two slant regions C. One slant region C may be located between the first gap region B1 and the central region D, and the other slant region C may be located between the second gap region B2 and the central region D. A quantity of slant regions C is not specifically limited in embodiments of this application.

As shown in FIG. 4, parts that are of the first electrode finger 11 and that are located in the edge region A, the gap region B, and the central region D are parallel to the first direction Y, and a part that is of the first electrode finger 11 and that is located in the slant region C is slanted relative to both the first direction Y and the second direction X. For example, an extension direction of the part that is of the first electrode finger 11 and that is located in the slant region C may be a straight line, or an extension direction of the part that is of the first electrode finger 11 and that is located in the slant region C may be an arc line. This is not limited in embodiments of this application.

FIG. 8 is a diagram of a slowness curve of a piezoelectric substrate 20 in an interdigital transducer 10 according to an embodiment of this application. A deflection angle is an included angle between a normal (for example, s9 in FIG. 4) of an extension direction of a first electrode finger 11 and a second direction X, and slowness is a reciprocal of a speed of a surface acoustic wave excited by the first electrode finger 11. Based on a slowness characteristic of an acoustic wave filter, there is a specific correlation between extension directions of electrode fingers in the acoustic wave filter and a sound speed of a surface acoustic wave excited by the electrode fingers. As shown in FIG. 8, when an included angle between a normal of an extension direction of a first electrode finger 11 and a second direction X is 0°, that is, when the extension direction of the first electrode finger 11 is perpendicular to the second direction X, a sound speed of a surface acoustic wave excited by the first electrode finger 11 is S. When an included angle between a normal of an extension direction of a first electrode finger 11 and a second direction X is greater than 0° and less than 90°, or the included angle is less than 0° and greater than -90°, a sound speed of a surface acoustic wave excited by the first electrode finger 11 is less than S. A slant region C is disposed. In this way, the sound speed of the excited surface acoustic wave at a part that is of the first electrode finger 11 and that is located in the slant region C is reduced.

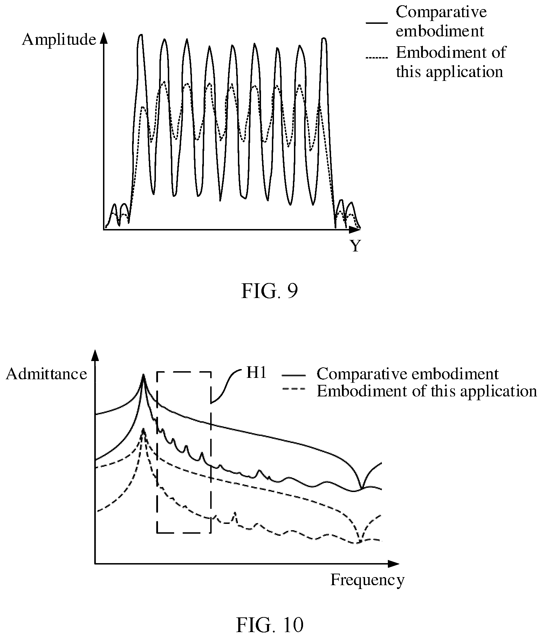

FIG. 9 is a diagram of amplitude curves, in a frequency range in a transverse mode, of the interdigital transducer 10 in FIG. 4 and an interdigital transducer 10 provided with no slant region. A comparative embodiment in FIG. 9 is the interdigital transducer 10 provided with no slant region, and an embodiment of this application in FIG. 9 is the interdigital transducer 10 in FIG. 4. With reference to FIG. 9, it can be learned that a sound speed of an excited surface acoustic wave at a part that is of a first electrode finger 11 and that is located in a slant region C is reduced, so that the part can form a waveguide, to adjust charge distribution of an interdigital electrode in a second direction X and further suppress excitation of a transverse mode.

FIG. 10 is a diagram of conductivity curves of the interdigital transducer 10 in FIG. 4 and an interdigital transducer 10 provided with no slant region. A comparative embodiment in FIG. 10 is the interdigital transducer 10 provided with no slant region, and an embodiment of this application in FIG. 10 is the interdigital transducer 10 in FIG. 4. Further, with reference to FIG. 10, it can be learned that, compared with that of the interdigital transducer 10 provided with no slant region, a conductivity curve of the interdigital transducer 10 provided in this embodiment of this application is smoother in a low-order range (for example, at a place H1 in the figure). The foregoing disposal helps suppress excitation of a low-order transverse mode.

Still with reference to FIG. 4, in any one of the first electrode finger 11 and the second electrode finger 12 that are oppositely disposed at an interval in the first direction Y, the part that is of the first electrode finger 11 and that is located in the central region D is located on a first side of the opposite second electrode finger 12. For example, the right side of the second electrode finger 12 at a location shown in the figure is the first side. As described in the foregoing embodiment, the first electrode finger 11 and the second electrode finger 12 that are oppositely disposed at an interval in the first direction Y are an electrode finger group. In a same electrode finger group, the first electrode finger 11 is located on the first side of the second electrode finger 12. In other words, the first electrode finger 11 is located on the right side of the second electrode finger 12. Based on the foregoing disposal, in a same slant region C, deflection angles of parts that are of first electrode fingers 11 and that are located in the slant region C are the same. This helps improve normalization of the first electrode fingers 11 and facilitates reduction of difficulty in producing the acoustic filter 02. In addition, as described in the foregoing embodiment, because the inclination angle of the part located in the slant region C is related to the slowness characteristic of the acoustic wave filter, based on the foregoing disposal, the first electrode fingers 11 located in the same slant region C have a same suppression effect on the transverse mode.

Certainly, in some other embodiments, the first side may alternatively be the left side of the second electrode finger 12 at a location shown in the figure. In a same electrode finger group, the first electrode finger 11 is located on the first side of the second electrode finger 12. In other words, the first electrode finger 11 is located on the left side of the second electrode finger 12.

In conclusion, in the interdigital transducer 10 included in the acoustic filter 02 provided in embodiments of this application, the edge region A, the gap region B, the central region D, and the slant region C that are arranged in the first direction Y are included between the first bus bar 101 and the second bus bar 102. The parts that are of the first electrode finger 11 and that are located in the edge region A, the gap region B, and the central region D are parallel to the first direction Y, and the part that is of the first electrode finger 11 and that is located in the slant region C is slanted relative to both the first direction Y and the second direction X. The slant region C is disposed. In this way, the sound speed of the excited surface acoustic wave at the part that is of the first electrode finger 11 and that is located in the slant region C is reduced, so that the part can form the waveguide, to adjust charge distribution of the interdigital electrode in the second direction X and further suppress excitation of the transverse mode. Compared with that in adjustment of a shape of an overall structure of the interdigital transducer 10, excitation of the transverse mode in embodiments of this application is suppressed by disposing the slant region C. Only extension directions of parts of the first electrode fingers 11 need to be adjusted. This helps reduce the area occupied by the resonator 100. On the basis of this, in any one of the first electrode finger 11 and the second electrode finger 12 that are oppositely disposed at an interval in the first direction Y, the part that is of the first electrode finger 11 and that is located in the central region D is located on the first side of the opposite second electrode finger 12. Based on the foregoing disposal, in a same slant region C, extension directions of parts that are of first electrode fingers 11 and that are located in the slant region C are the same. This facilitates reduction of difficulty in producing the acoustic filter 02. In addition, because inclination angles of the parts located in the slant region C are related to the slowness characteristic of the acoustic wave filter, the first electrode fingers 11 located in the same slant region C have the same suppression effect on the transverse mode.

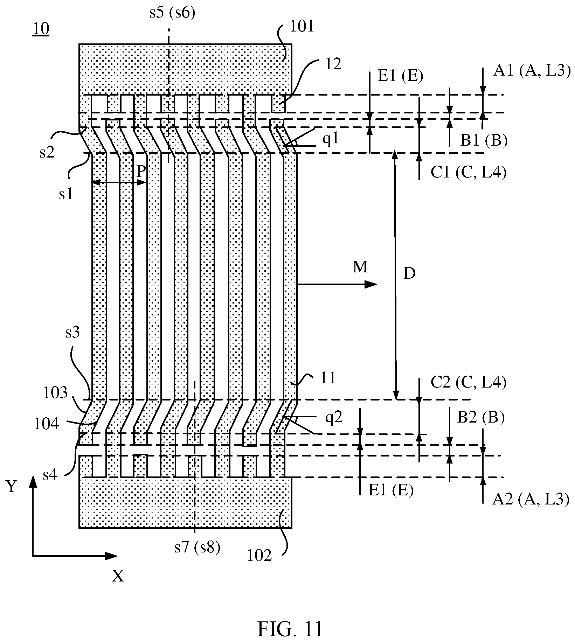

FIG. 11 is a diagram of a structure of another interdigital transducer 10 according to an embodiment of this application. As shown in FIG. 11, a transition region E may be further included between a first bus bar 101 and a second bus bar 102. The transition region E is bordered between a slant region C and a gap region B. A part that is of a first electrode finger 11 and that is located in the transition region E is parallel to a first direction Y. For example, a quantity of transition regions E is the same as a quantity of slant regions C. For example, there may be one transition region E and one slant region C. The transition region E is bordered between the slant region C and a first gap region B1, or the transition region E is bordered between the slant region C and a second gap region B2.

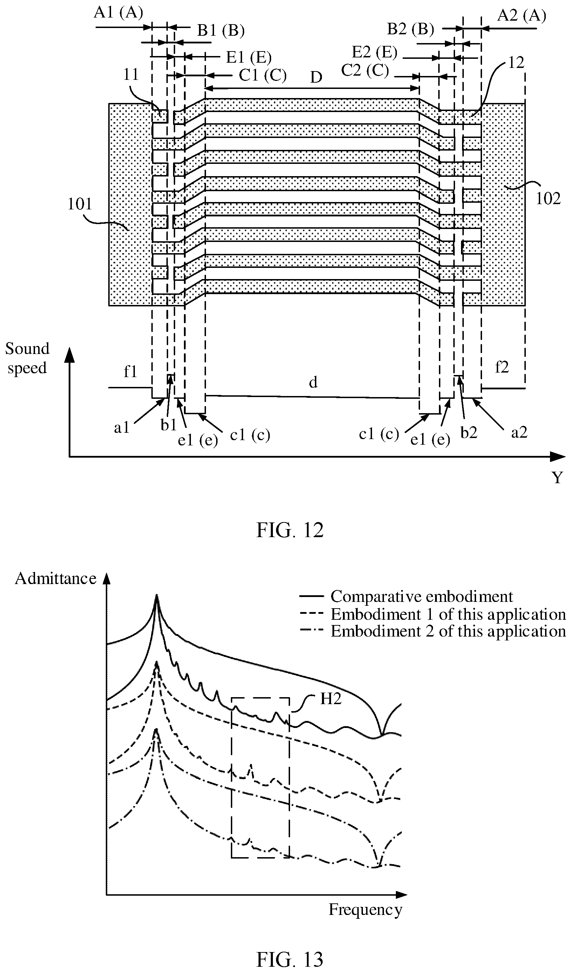

FIG. 12 is a diagram of a sound speed curve corresponding to the interdigital transducer 10 in FIG. 11. As shown in FIG. 12, a sound speed curve corresponding to the first bus bar 101 is a segment f1, and a sound speed curve corresponding to the second bus bar 102 is a segment f2. A sound speed region corresponding to an interdigital electrode located in a first edge region A1 is a segment a1, and a sound speed region corresponding to the interdigital electrode located in a second edge region A2 is a segment a2. A sound speed in the segment a1 is lower than a sound speed in the segment f1, and a sound speed in the segment a2 is lower than a sound speed in the segment f2. A sound speed region corresponding to the interdigital electrode located in the first gap region B1 is a segment b 1, and a sound speed region corresponding to the interdigital electrode located in the second gap region B2 is a segment b2. A sound speed in the segment b1 is higher than a sound speed in the segment a1, and a sound speed in the segment b2 is higher than a sound speed in the segment a2. A sound speed region corresponding to the interdigital electrode located in the slant region C is a segment c, and a sound speed in the segment c is lower than sound speeds in the segment a1 and the segment a2. It can be learned that a sound speed change between the gap region B and the slant region C is large. It may be understood that the interdigital electrode with a sudden change of sound speed excites spurious acoustic waves in other modes. As a result, performance of a resonator 100 is deteriorated.

A sound speed region corresponding to the interdigital electrode located in the transition region E is a segment e. A sound speed in the segment e is lower than sound speeds in the segment b1 and the segment b2, and is higher than a sound speed in the segment c. The transition region E is disposed. This helps avoid a sudden change of a sound speed between the slant region C and the gap region B, thereby suppressing impact of the spurious acoustic waves in other modes.

Still with reference to FIG. 11, there may be two transition regions E and two slant regions C. The gap region B may include the first gap region B1 and the second gap region B2 that are disposed opposite to each other in the first direction Y, and the slant region C may include a first slant region C1 and a second slant region C2 that are disposed in the first direction Y The first gap region B1 may be located between the first edge region A1 and the first slant region C1, and the second gap region B2 may be located between the second edge region A2 and the second slant region C2. The first slant region C1 and the second slant region C2 are disposed. In this way, a speed of an excited sound at parts that are of a first interdigital electrode and that are located in the first slant region C1 and the second slant region C2 is reduced, so that the parts located in the first slant region C1 and the second slant region C2 can form a waveguide, to further adjust charge distribution of the interdigital electrode in a second direction X and further suppress excitation of a transverse mode.

Still with reference to FIG. 12, a sound speed region corresponding to the interdigital electrode located in the first slant region C1 is a segment c1, and a sound speed region corresponding to the interdigital electrode located in the second slant region C2 is a segment c2. A sound speed in the segment c1 is lower than a sound speed in the segment b1, and a sound speed in the segment c2 is lower than a sound speed in the segment c2. A sound speed region corresponding to the interdigital electrode located in a first transition region E1 is a segment e1, and a sound speed region corresponding to the interdigital electrode located in a second transition region E2 is a segment e2. A sound speed in the segment e1 is lower than a sound speed in the segment b1 and is higher than a sound speed in the segment c1, and a sound speed in the segment e2 is lower than a sound speed in the segment b2 and is higher than a sound speed in the segment c2. The first transition region E1 and the second transition region E2 are disposed. This helps further avoid generation of effects such as bulk acoustic wave scattering, thereby avoiding generation of another spurious mode.

Still with reference to FIG. 11, the first slant region C1 may include a first boundary line s1 and a second boundary line s2 that are disposed in the first direction Y, and there is a first preset included angle q1 between the second direction X and a normal of a connection line between a midpoint of the first electrode finger 11 on the first boundary line s1 and a midpoint of the first electrode finger 11 on the second boundary line s2. For example, the first boundary line s1 is located between the first slant region C1 and a middle region, and the second boundary line s2 is located between the first slant region C1 and the first transition region E1. Based on the foregoing disposal, a part that is of the first electrode finger 11 and that is located in the first slant region C1 is slanted relative to both the first direction Y and the second direction X.

In some embodiments, the first preset included angle q1 ranges from 3° to 20°. For example, the first preset included angle q1 may be 3°, 9°, or 20°. Based on the foregoing disposal, the part that is of the first electrode finger 11 and that is located in the first slant region C1 can form a waveguide to suppress excitation of the transverse mode.

Similarly, the second slant region C2 may include a third boundary line s3 and a fourth boundary line s4 that are disposed in the first direction Y, and there is a second preset included angle q2 between the second direction X and a normal of a connection line between a midpoint of the first electrode finger 11 on the third boundary line s3 and a midpoint of the first electrode finger 11 on the fourth boundary line s4. For example, the third boundary line s3 is located between the second slant region C2 and the middle region, and the fourth boundary line s4 is located between the second slant region C2 and the second transition region E2. Based on the foregoing disposal, a part that is of the first electrode finger 11 and that is located in the second slant region C2 is slanted relative to both the first direction Y and the second direction X.

In some embodiments, the second preset included angle q2 ranges from -3° to -20°. For example, the second preset included angle q2 may be -3°, -9°, or -20°. Based on the foregoing disposal, the part that is of the first electrode finger 11 and that is located in the second slant region C2 can form a waveguide to suppress excitation of the transverse mode.

With reference to FIG. 8, for an acoustic wave filter having a symmetric slowness characteristic, absolute values of the first preset included angle q1 and the second preset included angle q2 may be the same. For a case in which a slowness curve is asymmetric with respect to an axis Sx, absolute values of the first preset included angle q1 and the second preset included angle q2 may be different. This maintains consistency of sound speeds in the first slant region C1 and the second slant region C2.

Still with reference to FIG. 11, a center line s5 of a part that is of the second electrode finger 12 and that is located in the first edge region A1 coincides with a center line s6 of a part that is of the first electrode finger 11 and that is located in the first transition region E1. A center line s7 of a part that is of the second electrode finger 12 and that is located in the second edge region A2 coincides with a center line s8 of a part that is of the first electrode finger 11 and that is located in the second transition region E2. Based on the foregoing disposal, in a direction from the first electrode finger 11 to the second electrode finger 12, a sudden change of sound impedance is avoided. This avoids generation of effects such as bulk acoustic wave scattering, thereby avoiding generation of another spurious mode.

Still with reference to FIG. 11, a length L3 of a part that is of the interdigital electrode and that is located in the edge region A may range from 0.2λ to 3λ, and a length L4 of a part that is of the interdigital electrode and that is located in the transition region E may range from 0.1λ to 1λ, where λ is a period length P of the interdigital electrode. Herein, the period length Pisa distance between two adjacent first interdigital electrodes that are connected to the first bus bar 101. For example, the length L3 of the part that is of the interdigital electrode and that is located in the edge region A is 0.2λ, 1.5λ, or 3λ, and the length L4 of the part that is of the interdigital electrode and that is located in the transition region E is 0.1λ, 0.5λ, or 1λ.

For example, when the length of the part that is of the interdigital electrode and that is located in the edge region A approaches 0.2λ, and the length of the part that is of the interdigital electrode and that is located in the transition region E approaches 0.1λ, an area occupied by the interdigital electrode is reduced. When the length of the part that is of the interdigital electrode and that is located in the edge region A approaches 3λ, and the length of the part that is of the interdigital electrode and that is located in the transition region E approaches 1λ, a suppression effect on the transverse mode is improved.

FIG. 13 is a diagram of conductivity curves of the interdigital transducer 10 in FIG. 4, the interdigital transducer 10 in FIG. 11, and an interdigital transducer 10 provided with no slant region. An embodiment 1 of this application in FIG. 13 is a conductivity curve of the interdigital transducer 10 in FIG. 4, an embodiment 2 of this application in FIG. 13 is a conductivity curve of the interdigital transducer 10 in FIG. 11, and a comparative embodiment in FIG. 13 is a conductivity curve of the interdigital transducer 10 provided with no slant region. With reference to FIG. 11 and FIG. 13, it can be learned that, compared with that of the interdigital transducer 10 provided with no slant region, the length L3 of the part that is of the interdigital electrode and that is located in the edge region A and the length L4 of the part that is of the interdigital electrode and that is located in the transition region E are set. As a result, conductivity curves of the interdigital transducers 10 provided in embodiments of this application are smoother in a high-order range (for example, H2 in the figure). This helps suppress excitation of a high-order transverse mode.

Still with reference to FIG. 11, a width of a part that is of the first electrode finger 11 and that is located in the slant region C may be equal to a width of a part that is of the first electrode finger 11 and that is located in the central region D. For example, an edge that is of the first electrode finger 11 and that is located in the slant region C includes a first edge 103 and a second edge 104 that are disposed opposite to each other. The "width" is a distance between the first edge 103 and the second edge 104. For example, the first edge 103 and the second edge 104 may be disposed in parallel with each other, and the first edge 103 and the second edge 104 are bordered between the transition region E and the central region D. Based on the foregoing disposal, the width of the part that is of the first electrode finger 11 and that is located in the slant region C is equal to the width of the part that is of the first electrode finger 11 and that is located in the central region D.

Certainly, in some other embodiments, the width of the part that is of the first electrode finger 11 and that is located in the slant region C may alternatively be less than the width of the part that is of the first electrode finger 11 and that is located in the central region D. A relative width between the part that is of the first electrode finger 11 and that is located in the slant region C and the part that is of the first electrode finger 11 and that is located in the central region D is not specifically limited in embodiments of this application.

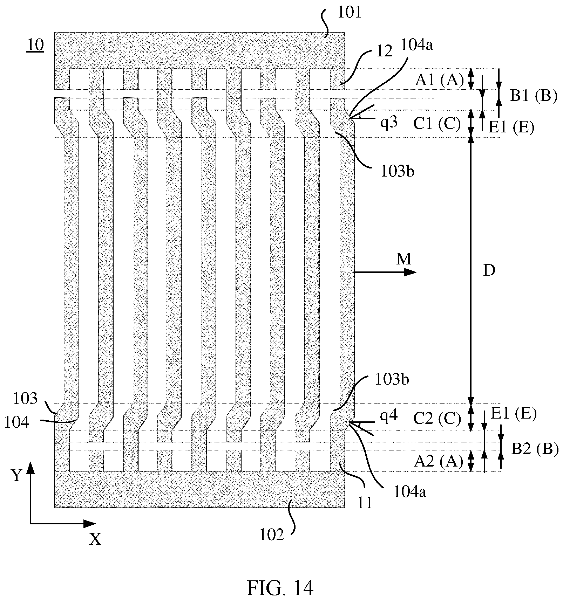

FIG. 14 is a diagram of a structure of another interdigital transducer 10 according to an embodiment of this application. With reference to FIG. 14, in some other embodiments, a first edge 103 and a second edge 104 may alternatively be in another shape, and a distance between the first edge 103 and the second edge 104 may be greater than a width of a part that is of a first electrode finger 11 and that is located in a central region D, so that a width of a part that is of the first electrode finger 11 and that is located in a slant region C is greater than the width of the part that is of the first electrode finger 11 and that is located in the central region D. Because a material of the first electrode finger 11 generally includes metal, when the width of the part that is of the first electrode finger 11 and that is located in the slant region C is greater than the width of the part that is of the first electrode finger 11 and that is located in the central region D, a metallization ratio of the first electrode finger 11 located in the slant region C is increased. This helps further reduce a sound speed corresponding to the slant region C, thereby suppressing excitation of a transverse mode.

For example, a ratio of a sum of widths of parts that are of first electrode fingers 11 and that are located in the slant region C to a width of the slant region C in a second direction X may range from 0.6 to 0.8. For example, the ratio of the sum of the widths of the parts that are of the first electrode fingers 11 and that are located in the slant region C to the width of the slant region C in the second direction X may be 0.6, 0.7, or 0.8. The foregoing disposal helps further reduce the sound speed corresponding to the slant region C, thereby suppressing excitation of the transverse mode.

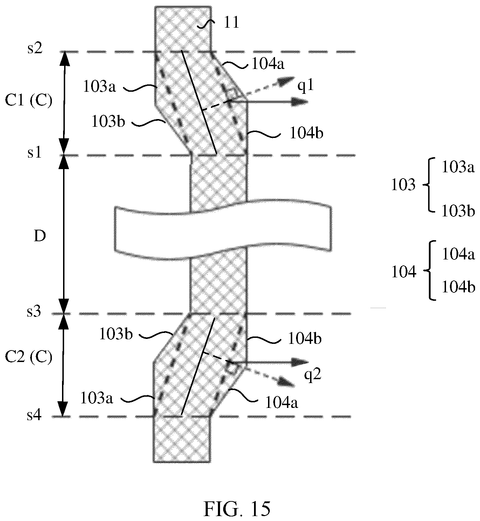

In some embodiments, an edge that is of the first electrode finger 11 and that is located in the slant region C may include a straight line segment. FIG. 15 is a partially enlarged diagram of the part that is of the first electrode finger 11 in FIG. 14 and that is located in the slant region C. With reference to FIG. 15, for example, the first edge 103 may further include a plurality of straight line segments, and the second edge 104 may further include a plurality of straight line segments. A graph enclosed by the first edge 103 and the second edge 104 may be a polygon.

For example, the first edge 103 may include a first segment 103a and a second segment 103b, and both the first segment 103a and the second segment 103b are straight line segments. The second edge 104 may include a third segment 104a and a fourth segment 104b, and both the third segment 104a and the fourth segment 104b are straight line segments. A part that is of the first electrode finger 11 and that is located in a transition region E is connected to both the first segment 103a and the third segment 104a, and the part that is of the first electrode finger 11 and that is located in the central region D is connected to both the second segment 103b and the fourth segment 104b. Extension directions of the third segment 104a and the second segment 103b are parallel to a first direction Y, the first segment 103a and the fourth segment 104b are parallel to each other, and the third segment 104a and the second segment 103b are inclined relative to both the first direction Y and the second direction X. Based on the foregoing disposal, a graph enclosed by the first edge 103 and the second edge 104 may be a hexagon, and the distance between the first edge 103 and the second edge 104 is greater than the width of the part that is of the first electrode finger 11 and that is located in the central region D. In this way, the width of the part that is of the first electrode finger 11 and that is located in the slant region C is greater than the width of the part that is of the first electrode finger 11 and that is located in the central region D.

As described in the foregoing embodiment, there is a first preset included angle q1 between the second direction X and a normal of a connection line between a midpoint of the first electrode finger 11 on a first boundary line s1 and a midpoint of the first electrode finger 11 on a second boundary line s2. There is a second preset included angle q2 between the second direction X and a normal of a connection line between a midpoint of the first electrode finger 11 on a third boundary line s3 and a midpoint of the first electrode finger 11 on a fourth boundary line s4. Value ranges of the first preset included angle q1 and the second preset included angle q2 are not described herein again.

Further, in a first slant region C1, there may further be third preset included angles q3 between a normal of the second segment 103b and the third segment 104a and the second direction X. The third preset included angle q3 ranges from 3° to 20°. For example, the third preset included angle q3 may be 3°, 9°, or 20°. Based on the foregoing disposal, a part that is of the first electrode finger 11 and that is located in the first slant region C1 can form a waveguide to suppress excitation of the transverse mode.

Further, in a second slant region C2, there may be fourth preset included angles q4 between a normal of the second segment 103b and the third segment 104a and the second direction X. The fourth preset included angle q4 ranges from -3° to -20°. For example, the fourth preset included angle q4 may be -3°, -9°, or -20°. Based on the foregoing disposal, a part that is of the first electrode finger 11 and that is located in the second slant region C2 can form a waveguide to suppress excitation of the transverse mode.

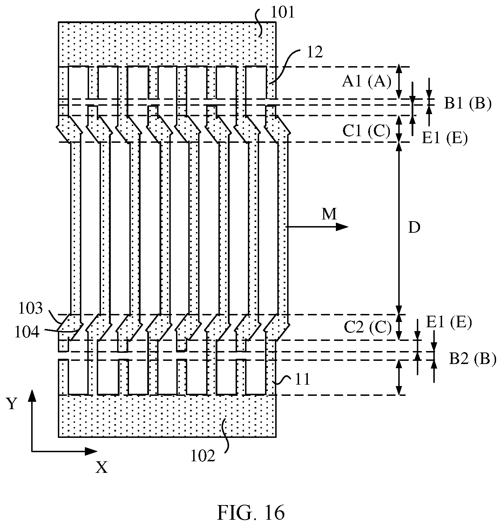

Certainly, in some other embodiments, the first edge 103 and the second edge 104 may alternatively be of another structure. FIG. 16 is a diagram of a structure of another interdigital transducer 10 according to an embodiment of this application. With reference to FIG. 16, a graph enclosed by a first edge 103 and a second edge 104 may alternatively be a rectangle, and a distance between two rectangular edges that are disposed opposite to each other is greater than a width of a part that is of a first electrode finger 11 and that is located in a central region D.

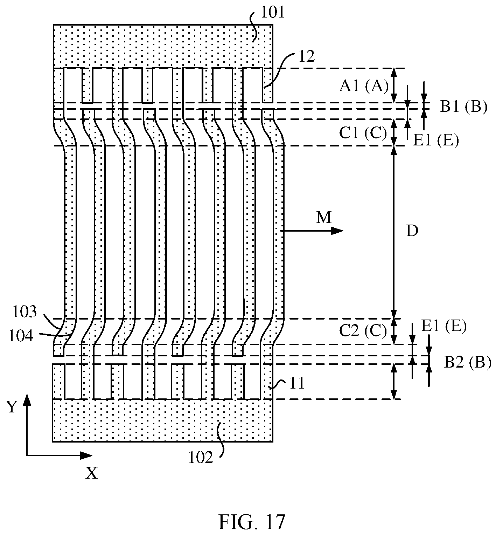

In some other embodiments, an edge that is of the first electrode finger 11 and that is located in a slant region C includes an arc line segment. FIG. 17 is a diagram of a structure of another interdigital transducer 10 according to an embodiment of this application. With reference to FIG. 17, for example, both a first edge 103 and a second edge 104 are arc line segments. One end of an arc line segment is connected to a central region D, and the other end of the arc line segment is connected to a transition region E.

In conclusion, shapes of the first edge 103 and the second edge 104 are not specifically limited in embodiments of this application, provided that the distance between the first edge 103 and the second edge 104 is greater than or equal to the width of the part that is of the first electrode finger 11 and that is located in the central region D.

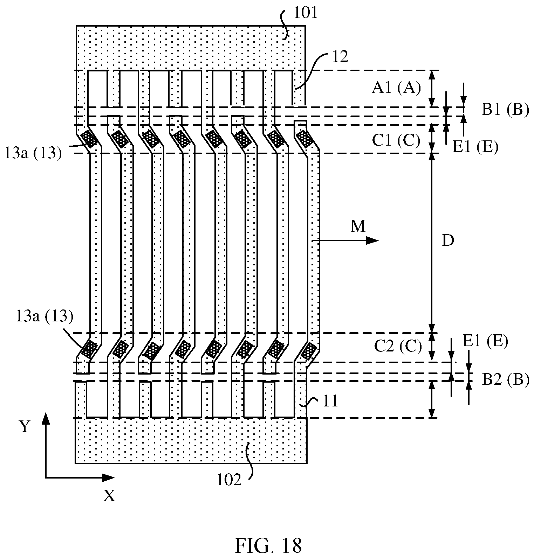

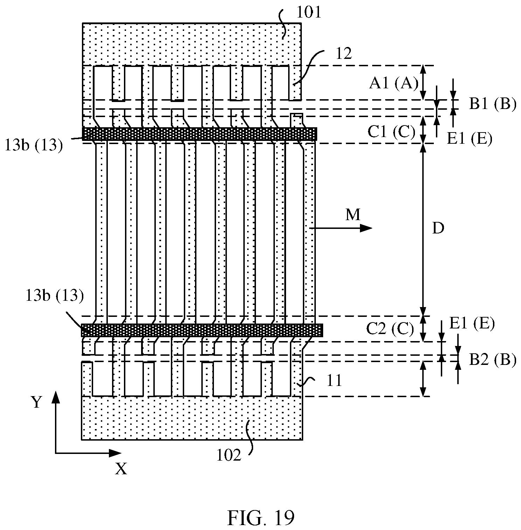

FIG. 18 is a diagram of a structure of another interdigital transducer 10 according to an embodiment of this application, and FIG. 19 is a diagram of a structure of another interdigital transducer 10 according to an embodiment of this application.

With reference to FIG. 18 and FIG. 19, the interdigital transducer 10 may further include a load portion 13. The load portion 13 is located in a slant region C, and is located on a side that is of a first electrode finger 11 and that is away from a piezoelectric substrate 20. The load portion 13 is disposed. This helps increase mass load of the first electrode finger 11 in the slant region C and further reduce a sound speed corresponding to the slant region C, thereby suppressing excitation of a transverse mode.

With reference to FIG. 18, in some embodiments, the load portion 13 may include a conducting layer 13a, and an orthographic projection of the conducting layer 13a on the piezoelectric substrate 20 is located within an orthographic projection of the first electrode finger 11 on the piezoelectric substrate 20. A material of the conducting layer 13a may include metal. For example, there may be a plurality of conducting layers 13a, and one conducting layer 13a corresponds to one part that is of the first electrode finger 11 and that is located in the slant region C. An orthographic projection of the conducting layer 13a on the piezoelectric substrate 20 is located within an orthographic projection of a first electrode finger 11 corresponding to the conducting layer 13a on the piezoelectric substrate 20. In this way, the plurality of conducting layers 13a are electrically isolated from each other. This avoids a short circuit between adjacent first electrode fingers 11.

With reference to FIG. 19, in some other embodiments, the load portion 13 may include a dielectric layer 13b. The dielectric layer 13b is parallel to a second direction X, and at least a part that is of the first electrode finger 11 and that is located in the slant region C overlaps the dielectric layer 13b. A material of the dielectric layer 13b may include one or more of silicon nitride, silicon oxide, and silicon oxynitride. For example, the dielectric layer 13b may be of a long-strip structure extending in the second direction X. Because the dielectric layer 13b does not have a conductive property, adjacent first electrode fingers 11 are electrically isolated from each other. This avoids a short circuit between the adjacent first electrode fingers 11.

In addition, the dielectric layer 13b is of a continuous structure extending in the second direction X. This helps reduce difficulty in manufacturing the dielectric layer 13b.

Based on the foregoing structure, in an embodiment in which the interdigital transducer 10 includes the slant region C, when the transverse mode is suppressed, an unwanted spurious wave may be generated. The spurious wave has an obvious transverse component. The transverse component of the spurious wave further affects flatness of a passband, and increases an insertion loss of an acoustic filter 01. For ease of description, the transverse component of the spurious wave is referred to as an inclination transverse mode herein.

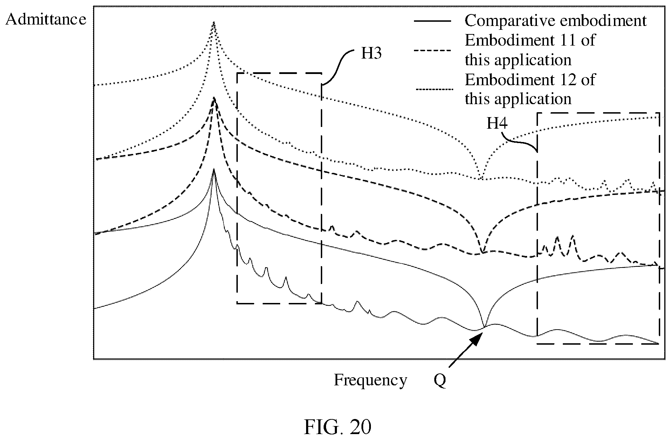

FIG. 20 is a diagram of conductivity curves of an interdigital transducer 10 provided with a slant region C and a grid region G3, an interdigital transducer 10 provided with only a slant region C, and an interdigital transducer 10 provided with no slant region C. As shown in FIG. 20, a comparative embodiment in FIG. 20 is a conductivity curve of the interdigital transducer 10 provided with no slant region C. An embodiment 11 of this application in FIG. 20 is a conductivity curve of the interdigital transducer 10 in FIG. 4. In a region H3, a conductivity curve of the interdigital transducer 10 provided with the slant region C is smoother when compared with the conductivity curve of the interdigital transducer 10 provided with no slant region C. However, in a region H4 (where a frequency is greater than that at an anti-resonance point Q, for example, a frequency range may be 2000 MHz to 2050 MHz), the conductivity curve of the interdigital transducer 10 provided with the slant region C fluctuates greatly when compared with the conductivity curve of the interdigital transducer 10 provided with no slant region C. It can be learned that the interdigital transducer 10 provided with the slant region C causes an unwanted inclination transverse mode.

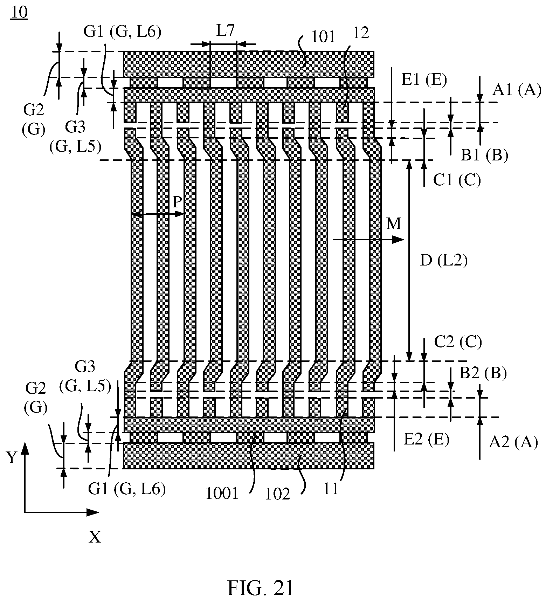

To further suppress the inclination transverse mode, an embodiment of this application further provides another interdigital transducer 10. FIG. 21 is a diagram of a structure of another interdigital transducer 10 according to an embodiment of this application. As shown in FIG. 21, each of a first bus bar 101 and a second bus bar 102 includes a first convergence region G1, a grid region G3, and a second convergence region G2 that are arranged in a first direction Y, and the grid region G3 is located between the first convergence region G1 and the second convergence region G2.

For example, a part that is of the first bus bar 101 and that is located in the first convergence region G1 may be bordered to an electrode finger. A part that is of the first bus bar 101 and that is located in the grid region G3 may be bordered between the part that is of the first bus bar 101 and that is located in the first convergence region G1 and a part that is of the first bus bar 101 and that is located in the second convergence region G2. Similarly, a part that is of the second bus bar 102 and that is located in the first convergence region G1 is bordered to an electrode finger. A part that is of the second bus bar 102 and that is located in the grid region G3 is bordered between the part that is of the second bus bar 102 and that is located in the first convergence region G1 and a part that is of the second bus bar 102 and that is located in the second convergence region G2.

Based on the foregoing structure, the part that is of the bus bar and that is located in the grid region G3 includes a plurality of grids 1001 disposed at intervals in a second direction X. For example, a cross section shape of a grid 1001 may be approximately a rectangle. Alternatively, in some other embodiments, a cross section shape of a grid 1001 may roughly include another shape, for example, a circle, a trapezoid, or a triangle. The cross section shape of the grid 1001 is not specifically limited in embodiments of this application. Further, a quantity and a size of the grids 1001 are not specifically limited in this application. The plurality of grids 1001 may be of, for example, structures in a same cross section shape, and the plurality of grids 1001 may be disposed at equal intervals, to improve normalization of the interdigital transducer 10.

Certainly, in some other embodiments, based on an actual requirement, the plurality of grids 1001 may be set to structures in different sizes, or intervals between the plurality of grids 1001 may be different.

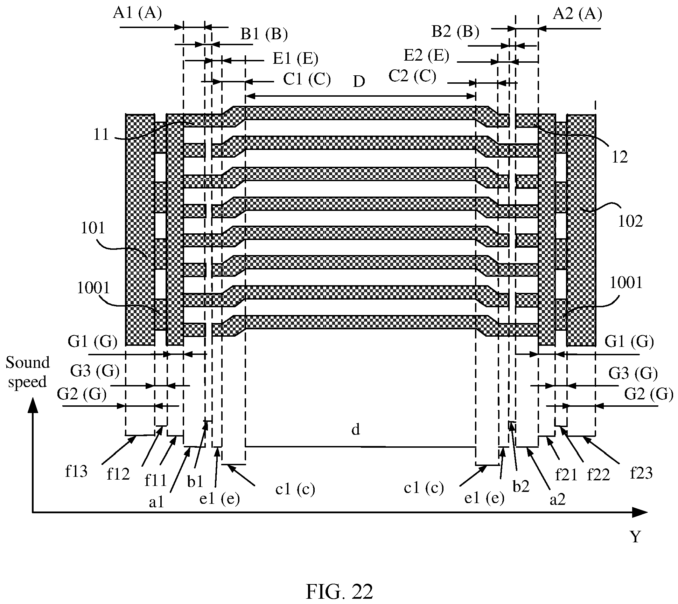

FIG. 22 is a diagram of sound speed distribution of a piezoelectric substrate in the interdigital transducer 10 in FIG. 21 in a first direction Y. As shown in FIG. 22, a sound speed curve corresponding to the first bus bar 101 is a segment f1, a sound speed curve corresponding to the part that is of the first bus bar 101 and that is located in the first convergence region G1 is a segment f11, a sound speed curve corresponding to the part that is of the first bus bar 101 and that is located in the grid region G3 is a segment f12, and a sound speed curve corresponding to the part that is of the first bus bar 101 and that is located in the second convergence region G2 is a segment f13. A sound speed in the segment f12 is higher than a sound speed in the segment f11, and a sound speed in the segment f12 is higher than a sound speed in the segment f13.

Similarly, a sound speed curve corresponding to the second bus bar 102 is a segment f2. A sound speed curve corresponding to the part that is of the second bus bar 102 and that is located in the first convergence region G1 is a segment f21, a sound speed curve corresponding to the part that is of the second bus bar 102 and that is located in the grid region G3 is a segment f22, and a sound speed curve corresponding to the part that is of the second bus bar 102 and that is located in the second convergence region G2 is a segment f23. A sound speed in the segment f22 is higher than a sound speed in the segment f21, and a sound speed in the segment f22 is higher than a sound speed in the segment f23.

It can be learned that, the grid region G3 is disposed in the bus bar. In this way, a new degree of freedom can be introduced into the grid region G3 of the bus bar, to adjust sound speed distribution corresponding to the bus bar. In addition, the grid region G3 is disposed in the bus bar, so that charge distribution of the bus bar can be further changed, to further change electric field distribution of the bus bar. By changing the electric field distribution of the bus bar and the corresponding sound speed distribution, an excitation condition of an inclination transverse mode can be weakened, and therefore the inclination transverse mode can be suppressed.

Still with reference to FIG. 20, an embodiment 12 of this application is the conductivity curve of the interdigital transducer 10 in FIG. 20. In the region H4, the conductivity curve of the interdigital transducer 10 provided with the slant region C and the grid region G3 is smoother when compared with a conductivity curve of the interdigital transducer 10 provided with only the slant region C. It can be learned that the interdigital transducer 10 provided with the grid region G3 can suppress the inclination transverse mode.

Further, the slant region C and the grid region G3 are disposed, so that a manufacturing process of the interdigital electrode does not need to be added. This helps avoid a decrease in manufacturing efficiency of an acoustic wave filter 01.

In some embodiments, with reference to FIG. 21, in the first direction Y, a width L6 of a part that is of the bus bar and that is located in the first bus bar 101 ranges from 0.05λ, to 2λ. For example, a width L6 of the part that is of the first bus bar 101 and that is located in the first bus bar 101 may be 0.05k, λ, or 2λ, and a width L6 of a part that is of the second bus bar 102 and that is located in the first bus bar 101 may also be 0.05λ, λ, or 2λ.

In some embodiments, with reference to FIG. 21, in the first direction Y, a width L5 of a part that is of the bus bar and that is located in the grid region G3 ranges from 0.05λ, to 5λ. For example, a width L5 of the part that is of the first bus bar 101 and that is located in the grid region G3 may be 0.05λ, 2.5λ, or 5λ, and a width L5 of the part that is of the second bus bar 102 and that is located in the grid region G3 may also be 0.05λ, 2.5λ, or 5λ. When the width L5 of the part that is of the bus bar and that is located in the grid region G3 approaches 0.05λ, it is helpful to further weaken an excitation condition of the inclination transverse mode, thereby improving an effect of suppressing the inclination transverse mode. When the width L5 of the part that is of the bus bar and that is located in the grid region G3 approaches 5λ, it is helpful to reduce difficulty in manufacturing the bus bar, thereby improving efficiency in manufacturing the bus bar.

In some embodiments, with reference to FIG. 21, in the second direction X, in the first bus bar 101, a spacing L7 between adjacent grids 1001 ranges from 0.5λ, to 2λ. Further, in the second direction X, in the second bus bar 102, a spacing L7 between adjacent grids 1001 ranges from 0.5λ, to 2λ.

Further, a metallization ratio of the part that is of the bus bar and that is located in the grid region G3 may range from 0.1 to 0.9. Herein, the "metallization ratio" is a ratio of a sum of widths of parts that are of the bus bar and that are located in the grid region G3 to a width of the grid region G3 in the second direction X. For example, a metallization ratio of the part that is of the first bus bar 101 and that is located in the grid region G3 may be 0.1, 0.5, or 0.9, and a metallization ratio of the part that is of the second bus bar 102 and that is located in the grid region G3 may also be 0.1, 0.5, or 0.9.

Further, the metallization ratio of the part that is of the bus bar and that is located in the grid region G3 may range from 0.3 to 0.7. For example, a metallization ratio of the part that is of the first bus bar 101 and that is located in the grid region G3 may be 0.3, 0.5, or 0.7, and a metallization ratio of the part that is of the second bus bar 102 and that is located in the grid region G3 may also be 0.3, 0.5, or 0.7.

When the metallization ratio of the part that is of the bus bar and that is located in the grid region G3 approaches 0.5, it is helpful to further weaken the excitation condition of the inclination transverse mode, thereby improving the effect of suppressing the inclination transverse mode.

In some embodiments, a location of the grid 1001 of the bus bar may be adjusted to further weaken the excitation condition of the inclination transverse mode, thereby improving the effect of suppressing the inclination transverse mode.

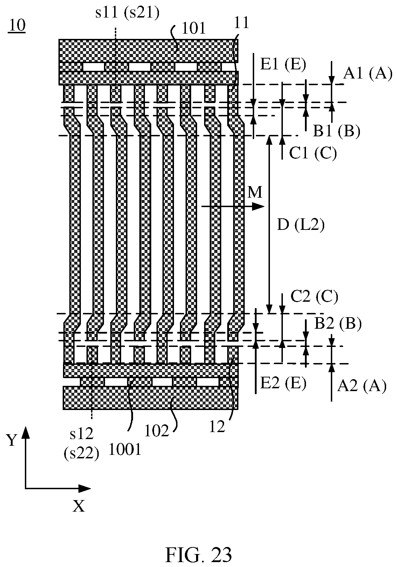

FIG. 23 is a diagram of a structure of another interdigital transducer 10 according to an embodiment of this application. In this embodiment, with reference to FIG. 23, a center line of a grid 1001 of a first bus bar 101 may be a first center line s11, and a center line of a grid 1001 of a second bus bar 102 may be a second center line s12. Both the first center line s11 and the second center line s12 extend in a first direction Y

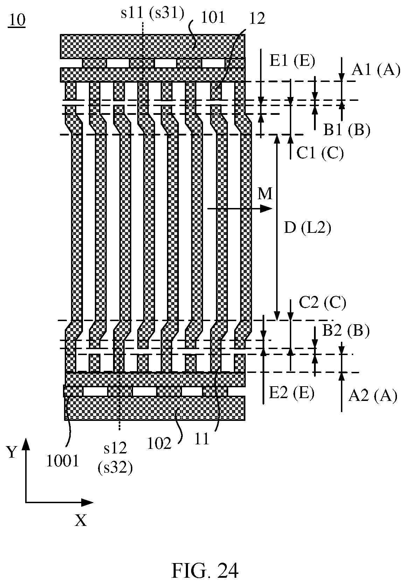

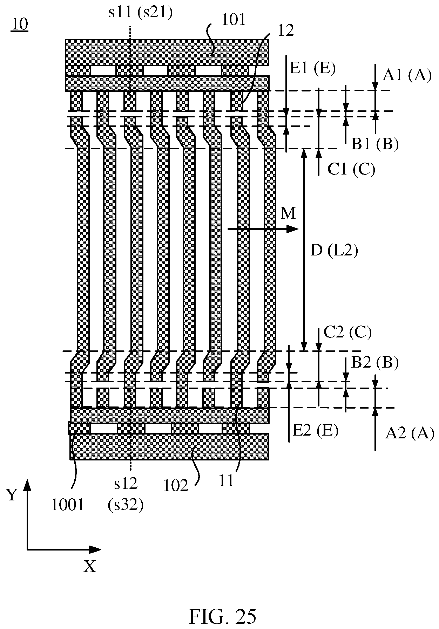

FIG. 24 is a diagram of a structure of another interdigital transducer 10 according to an embodiment of this application. FIG. 25 is a diagram of a structure of another interdigital transducer 10 according to an embodiment of this application. With reference to FIG. 23, FIG. 24, and FIG. 25, for example, the grid 1001 of the bus bar may be directly directed to an electrode finger, to further weaken an excitation condition of an inclination transverse mode.

In some embodiments, a center line of a part that is of a first electrode finger 11 or a second electrode finger 12 bordering the first bus bar 101 and that is located in an edge region A coincides with the first center line s11. A center line of a part that is of a first electrode finger 11 or a second electrode finger 12 bordering the second bus bar 102 and that is located in the edge region A coincides with the second center line s12.

As shown in FIG. 23, a center line s21 of a part that is of a second electrode finger 12 bordering the first bus bar 101 and that is located in the edge region A coincides with a first center line s11, and a center line s22 of a part that is of a second electrode finger 12 bordering the second bus bar 102 and that is located in the edge region A coincides with a second center line s12. For example, a plurality of grids 1001 of the first bus bar 101 may be disposed at equal intervals, and the plurality of grids 1001 may be in a one-to-one correspondence with a plurality of second electrode fingers 12 bordering the first bus bar 101; and a plurality of grids 1001 of the second bus bar 102 may be disposed at equal intervals, and the plurality of grids 1001 may be in a one-to-one correspondence with a plurality of second electrode fingers 12 bordering the second bus bar 102.

Further, still with reference to FIG. 23, the grids 1001 of the first bus bar 101 and the grids 1001 of the second bus bar 102 are disposed in a staggered manner in the first direction Y. For example, second electrode fingers 12 bordering the first bus bar 101 and second electrode fingers 12 bordering the second bus bar 102 are disposed in a staggered manner in the first direction Y In other words, first center lines s11 and second center lines s12 are disposed in the staggered manner in the first direction Y, and grids 1001 of the first bus bar 101 and grids 1001 of the second bus bar 102 are disposed in the staggered manner in the first direction Y.

As shown in FIG. 24, a center line s31 of a part that is of a first electrode finger 11 bordering the first bus bar 101 and that is located in the edge region A coincides with the first center line s11, and a center line s32 of a part that is of a first electrode finger 11 bordering the second bus bar 102 and that is located in the edge region A coincides with the second center line s12. For example, the plurality of grids 1001 of the first bus bar 101 may be in a one-to-one correspondence with a plurality of first electrode fingers 11 bordering the first bus bar 101, and a plurality of grids 1001 of the second bus bar 102 may be in a one-to-one correspondence with a plurality of first electrode fingers 11 bordering the second bus bar 102.

Further, still with reference to FIG. 24, the grids 1001 of the first bus bar 101 and the grids 1001 of the second bus bar 102 are disposed in a staggered manner in the first direction Y. For example, first electrode fingers 11 bordering the first bus bar 101 and first electrode fingers 11 bordering the second bus bar 102 are disposed in a staggered manner in the first direction Y. In other words, first center lines s11 and second center lines s12 are disposed in the staggered manner in the first direction Y, and the grids 1001 of the first bus bar 101 and the grids 1001 of the second bus bar 102 are disposed in the staggered manner in the first direction Y

As shown in FIG. 25, a center line s21 of a part that is of a second electrode finger 12 bordering the first bus bar 101 and that is located in the edge region A coincides with a first center line s11, and a center line s32 of a part that is of a first electrode finger 11 bordering the second bus bar 102 and that is located in the edge region A coincides with a second center line s12. For example, the plurality of grids 1001 of the first bus bar 101 may be in a one-to-one correspondence with a plurality of second electrode fingers 12 bordering the first bus bar 101, and the plurality of grids 1001 of the second bus bar 102 may be in a one-to-one correspondence with a plurality of first electrode fingers 11 bordering the second bus bar 102.

Further, still with reference to FIG. 25, the grids 1001 of the first bus bar 101 and the grids 1001 of the second bus bar 102 are symmetrically disposed. For example, for the first electrode finger 11 and the second electrode finger 12 that are disposed in the first direction Y, the part that is of the first electrode finger 11 and that is located in the edge region A and the part that is of the second electrode finger 12 and that is located in the edge region A may be symmetrically disposed. In other words, the first center line s11 and the second center line s12 are symmetrically disposed, and the grid 1001 of the first bus bar 101 and the grid 1001 of the second bus bar 102 are symmetrically disposed.

The foregoing disposal helps improve normalization of the interdigital transducer 10, further change electric field distribution and corresponding sound speed distribution of the bus bar, and further weaken the excitation condition of the inclination transverse mode, thereby suppressing the inclination transverse mode.

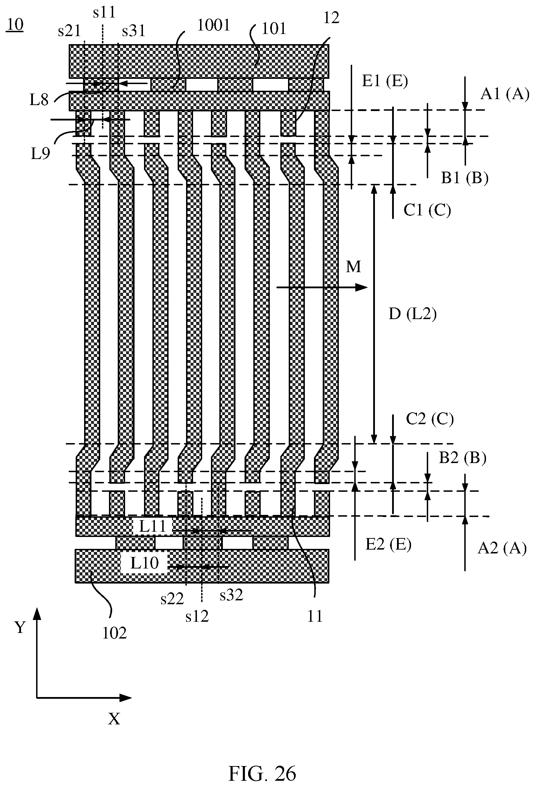

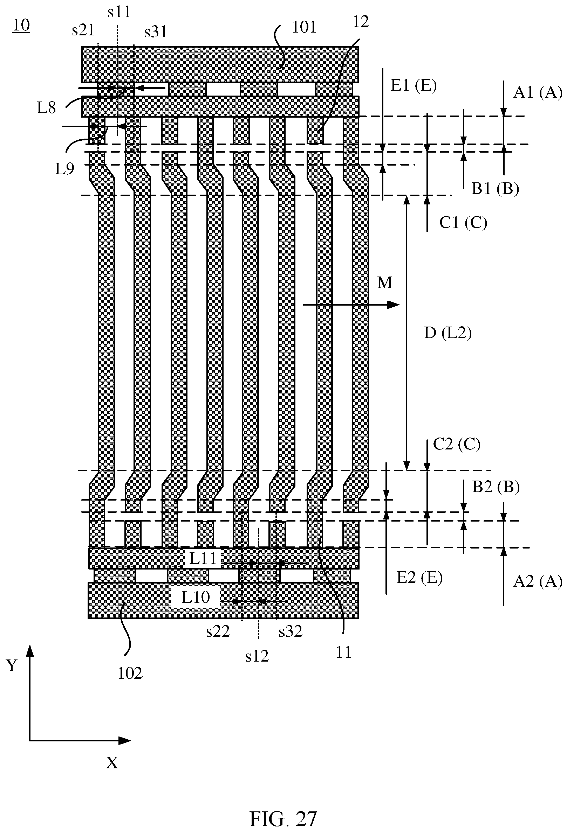

FIG. 26 is a diagram of a structure of another interdigital transducer 10 according to an embodiment of this application, and FIG. 27 is a diagram of a structure of another interdigital transducer 10 according to an embodiment of this application. For example, with reference to FIG. 26 and FIG. 27, a grid 1001 of a bus bar may face a gap between two adjacent electrode fingers in a second direction X, to further weaken an excitation condition of an inclination transverse mode.

As shown in FIG. 26, a first electrode finger 11 and a second electrode finger 12 that are adjacent in the second direction X are located on two sides of a first center line s11, and a distance between the first electrode finger 11 and the center line is equal to a distance between the second electrode finger 12 and the center line.

For example, in first electrode fingers 11 and second electrode fingers 12 that are adjacent in the second direction X, in an electrode finger connected to a first bus bar 101, a distance L8 between a center line s31 of a part that is of the first electrode finger 11 and that is located in an edge region A and a first center line s11 is equal to a distance L9 between a center line s21 of the second electrode finger 12 and the first center line s11. In electrode fingers connected to the second bus bar 102, a distance L11 between a center line s32 of a part that is of a first electrode finger 11 and that is located in the edge region A and a second center line s12 is equal to a distance L10 between a center line s22 of a second electrode finger 12 and the second center line s12.

Based on the foregoing structure, in some embodiments, as shown in FIG. 26, grids 1001 of the first bus bar 101 and grids 1001 of the second bus bar 102 are disposed in a staggered manner in a first direction Y. For example, for two adjacent grids 1001 of the first bus bar 101, the second center line s12 may be located between two adjacent first center lines s11. Further, a distance between the second center line s12 and one of the first center lines s11 may be equal to a distance between the second center line s12 and the other first center line s11.

Based on the foregoing structure, in some other embodiments, as shown in FIG. 27, grids 1001 of the first bus bar 101 and grids 1001 of the second bus bar 102 may be symmetrically disposed. For example, a plurality of grids 1001 of the first bus bar 101 and a plurality of grids 1001 of the second bus bar 102 may be disposed in a one-to-one correspondence, and a first center line s11 of a grid 1001 overlaps a second center line s12 of a grid 1001, so that the grids 1001 of the first bus bar 101 and the grids 1001 of the second bus bar 102 are symmetrically disposed.

The foregoing disposal helps improve normalization of the interdigital transducer 10, further change electric field distribution and corresponding sound speed distribution of the bus bar, and further weaken an excitation condition of an inclination transverse mode, thereby suppressing the inclination transverse mode.

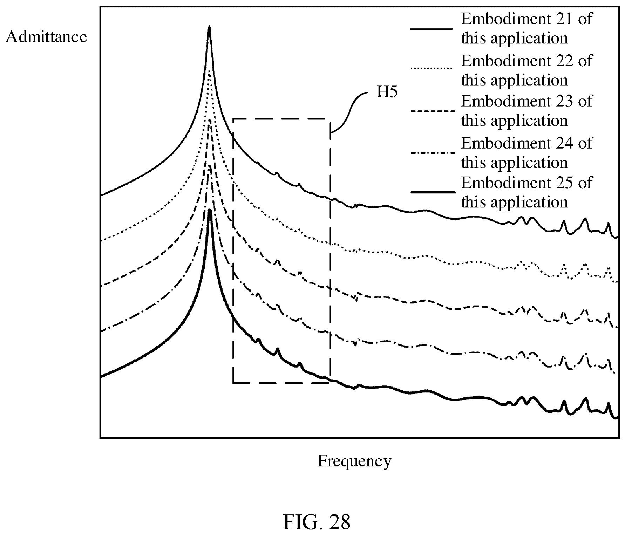

FIG. 28 is a diagram of conductivity curves of the interdigital transducer 10 in FIG. 23, the interdigital transducer 10 in FIG. 24, the interdigital transducer 10 in FIG. 25, the interdigital transducer 10 in FIG. 26, and the interdigital transducer 10 in FIG. 27. As shown in FIG. 28, an embodiment 21 of this application is a conductivity curve corresponding to the interdigital transducer 10 in FIG. 26, an embodiment 22 of this application is a conductivity curve corresponding to the interdigital transducer 10 in FIG. 27, an embodiment 23 of this application is a conductivity curve corresponding to the interdigital transducer 10 in FIG. 23, an embodiment 24 of this application is a conductivity curve corresponding to the interdigital transducer 10 in FIG. 24, and an embodiment 25 of this application is a conductivity curve corresponding to the interdigital transducer 10 in FIG. 25. In a region H5, the conductivity curves corresponding to the interdigital transducers 10 in FIG. 26 and FIG. 27 are smoother when compared with the conductivity curves corresponding to the interdigital transducers 10 in FIG. 23, FIG. 24, and FIG. 25. It can be learned that, when the grid 1001 of the bus bar faces the gap between the two adjacent electrode fingers in the second direction X, it is helpful to further weaken the excitation condition of the inclination transverse mode, to further weaken the excitation condition of the inclination transverse mode.

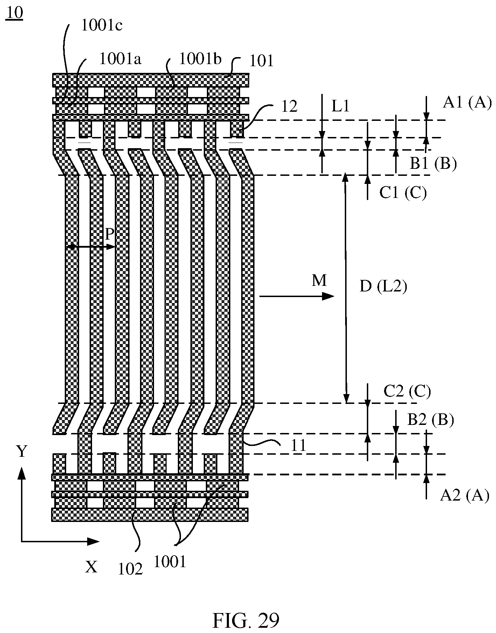

In some other embodiments, a grid region G3 in the bus bar may further include a plurality of grids 1001 disposed in the first direction Y FIG. 29 is a diagram of a structure of another interdigital transducer 10 according to an embodiment of this application. As shown in FIG. 29, a grid region G3 may include a first grid group 1001a and a second grid group 1001b that are disposed in a first direction Y, and the grid region G3 may further include a grid connection portion 1001c connected between the first grid group 1001a and the second grid group 1001b. An extension direction of the grid connection portion 1001c may extend, for example, in a second direction X.

The first grid group 1001a may include a plurality of grids 1001 that are disposed at intervals in the second direction X, and the second grid group 1001b may include a plurality of grids 1001 that are disposed at intervals in the second direction X. Locations and shapes of the plurality of grids 1001 in the first grid group 1001a are not specifically limited in this application, and locations and shapes of the plurality of grids 1001 in the second grid group 1001b are not specifically limited in this application. In some embodiments, the plurality of grids 1001 in the first grid region G3 may be in a one-to-one correspondence with the plurality of grids 1001 in the second grid group 1001b. Alternatively, in some other embodiments, the plurality of grids 1001 in the first grid region G3 and the plurality of grids 1001 in the second grid group 1001b may be disposed in a staggered manner in the second direction X.

The foregoing disposal helps change electric field distribution of the bus bar and corresponding sound speed distribution, and further weakens an excitation condition of an inclination transverse mode, thereby suppressing the inclination transverse mode.

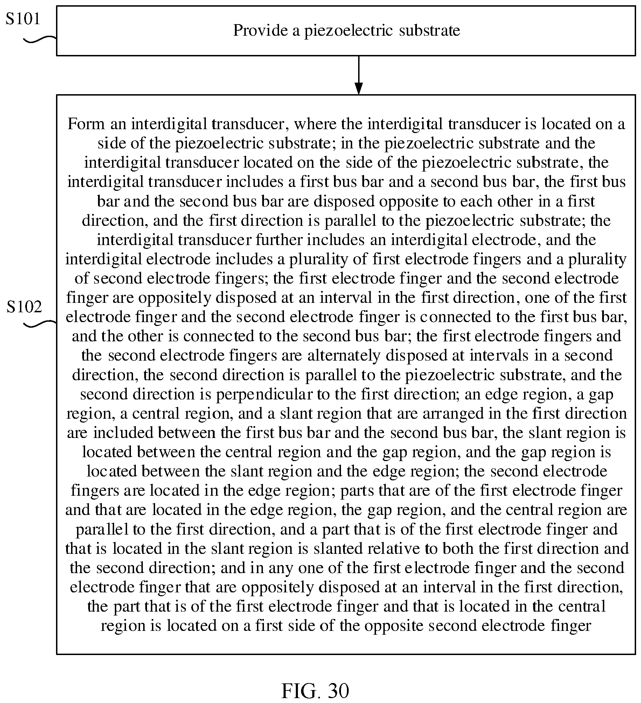

Based on the structure in any one of the foregoing embodiments, an embodiment of this application further provides a production method for an acoustic filter 02. FIG. 30 is a flowchart of steps of a production method for another acoustic filter 02 according to an embodiment of this application. With reference to FIG. 30, the production method includes the following steps.

S101: Provide a piezoelectric substrate.

A structure of a piezoelectric substrate 20 may be described in the foregoing embodiments, and details are not described herein again.

S102: Form an interdigital transducer, where the interdigital transducer is located on a side of the piezoelectric substrate; in the piezoelectric substrate and the interdigital transducer located on the side of the piezoelectric substrate, the interdigital transducer includes a first bus bar and a second bus bar, and the first bus bar and the second bus bar are disposed opposite to each other in a first direction; the first direction is parallel to the piezoelectric substrate; the interdigital transducer further includes an interdigital electrode, and the interdigital electrode includes a plurality of first electrode fingers and a plurality of second electrode fingers; a first electrode finger and a second electrode finger are oppositely disposed at an interval in the first direction, one of the first electrode finger and the second electrode finger is connected to the first bus bar, and the other is connected to the second bus bar; the first electrode fingers and the second electrode fingers are alternately disposed at intervals in a second direction, the second direction is parallel to the piezoelectric substrate, and the second direction is perpendicular to the first direction; an edge region, a gap region, a central region, and a slant region that are arranged in the first direction are included between the first bus bar and the second bus bar, the slant region is located between the central region and the gap region, and the gap region is located between the slant region and the edge region; the second electrode fingers are located in the edge region; parts that are of the first electrode finger and that are located in the edge region, the gap region, and the central region are parallel to the first direction, and a part that is of the first electrode finger and that is located in the slant region is slanted relative to both the first direction and the second direction; and in any one of the first electrode finger and the second electrode finger that are oppositely disposed at an interval in the first direction, the part that is of the first electrode finger and that is located in the central region is located on a first side of the opposite second electrode finger.

In an embodiment of this application, the steps of forming the interdigital transducer 10 may include the following.

Coat the piezoelectric substrate 20 with positive photoresist. A thickness of the positive photoresist may be 1.2 µm. After the positive photoresist is coated, expose and then bake the positive photoresist. After baking is completed, cool the positive photoresist, and finally perform developing, to form a photoresist groove. Deposit a metal material in the photoresist groove through evaporation coating, and remove a redundant metal material through wet etching (a stripping process). In this way, a patterned interdigital transducer 10 is formed. Then, remove a photoresist residue on the piezoelectric substrate 20 by using a cleaning fluid at a high temperature. A structure of the interdigital transducer 10 formed by using the foregoing process may be described in any one of the foregoing embodiments, and details are not described herein again.

In some embodiments, with reference to FIG. 18 and FIG. 19, a load portion 13 may be further formed on the interdigital transducer 10. For example, a conducting layer 13a or a dielectric layer 13b may be deposited on the interdigital transducer 10 by using processes such as physical vapor deposition (Physical Vapor Deposition, PVD) or chemical vapor deposition (Chemical Vapor Deposition, CVD), to form the load portion 13.

In conclusion, in the interdigital transducer 10 formed according to the production method for the acoustic filter 02 provided in this embodiment of this application, an edge region A, a gap region B, a central region D, and a slant region C that are arranged in a first direction Y are included between a first bus bar 101 and a second bus bar 102. Parts that are of a first electrode finger 11 and that are located in the edge region A, the gap region B, and the central region D are parallel to the first direction Y, and a part that is of the first electrode finger 11 and that is located in the slant region C is slanted relative to both the first direction Y and a second direction X. The slant region C is disposed. In this way, a sound speed of an excited surface acoustic wave at the part that is of the first electrode finger 11 and that is located in the slant region C is reduced, so that the part can form a waveguide, to adjust charge distribution of the interdigital electrode in the second direction X and further suppress excitation of a transverse mode. Compared with that in adjustment of a shape of an overall structure of the interdigital transducer 10, excitation of the transverse mode in embodiments of this application is suppressed by disposing the slant region C. Only extension directions of parts of the first electrode fingers 11 need to be adjusted. This helps reduce an area occupied by a resonator 100.

On the basis of this, in any one of the first electrode finger 11 and the second electrode finger 12 that are oppositely disposed at an interval in the first direction Y, the part that is of the first electrode finger 11 and that is located in the central region D is located on a first side of the opposite second electrode finger 12. Based on the foregoing disposal, in a same slant region C, extension directions of parts that are of first electrode fingers 11 and that are located in the slant region C are the same. This facilitates reduction of difficulty in producing the acoustic filter 02. In addition, because inclination angles of the parts located in the slant region C are related to a slowness characteristic of the acoustic wave filter, the first electrode fingers 11 located in the same slant region C have a same suppression effect on the transverse mode.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An acoustic filter, comprising a piezoelectric substrate and an interdigital transducer located on a side of the piezoelectric substrate, wherein
the interdigital transducer comprises a first bus bar and a second bus bar, the first bus bar and the second bus bar are disposed opposite to each other in a first direction, and the first direction is parallel to the piezoelectric substrate;
the interdigital transducer further comprises an interdigital electrode, and the interdigital electrode comprises a plurality of first electrode fingers and a plurality of second electrode fingers; a first electrode finger and a second electrode finger are oppositely disposed at an interval in the first direction, one of the first electrode finger and the second electrode finger is connected to the first bus bar, and the other is connected to the second bus bar; and the first electrode fingers and the second electrode fingers are alternately disposed at intervals in a second direction, the second direction is parallel to the piezoelectric substrate, and the second direction is perpendicular to the first direction;
an edge region, a gap region, a central region, and a slant region that are arranged in the first direction are comprised between the first bus bar and the second bus bar, the slant region is located between the central region and the gap region, and the gap region is located between the slant region and the edge region;
the second electrode fingers are located in the edge region; and
parts that are of the first electrode finger and that are located in the edge region, the gap region, and the central region are parallel to the first direction, and a part that is of the first electrode finger and that is located in the slant region is slanted relative to both the first direction and the second direction; and in any one of the first electrode finger and the second electrode finger that are oppositely disposed at an interval in the first direction, the part that is of the first electrode finger and that is located in the central region is located on a first side of the opposite second electrode finger.

2. The acoustic filter according to claim 1, wherein a transition region is further comprised between the first bus bar and the second bus bar, the transition region is bordered between the slant region and the gap region, and a part that is of the first electrode finger and that is located in the transition region is parallel to the first direction.

3. The acoustic filter according to claim 2, wherein a length of a part that is of the interdigital electrode and that is located in the edge region ranges from 0.1λ to 3λ, and a length of a part that is of the interdigital electrode and that is located in the transition region ranges from 0.1λ to 1λ, wherein λ is a period length of the interdigital electrode.

4. The acoustic filter according to any one of claims 1 to 3, wherein a width of the part that is of the first electrode finger and that is located in the slant region is greater than or equal to a width of the part that is of the first electrode finger and that is located in the central region.

5. The acoustic filter according to any one of claims 1 to 4, wherein the edge region comprises a first edge region and a second edge region that are disposed opposite to each other in the first direction, the gap region comprises a first gap region and a second gap region that are disposed opposite to each other in the first direction, and the slant region comprises a first slant region and a second slant region that are disposed opposite to each other in the first direction; and
the first gap region is located between the first edge region and the first slant region, and the second gap region is located between the second edge region and the second slant region.

6. The acoustic filter according to claim 5, wherein the first slant region comprises a first boundary line and a second boundary line that are disposed opposite to each other in the first direction, and there is a first preset included angle between the second direction and a normal of a connection line between a midpoint of the first electrode finger on the first boundary line and a midpoint of the first electrode finger on the second boundary line; and
the second slant region comprises a third boundary line and a fourth boundary line that are disposed opposite to each other in the first direction, and there is a second preset included angle between the second direction and a normal of a connection line between a midpoint of the first electrode finger on the third boundary line and a midpoint of the first electrode finger on the fourth boundary line.

7. The acoustic filter according to claim 5 or 6, wherein the first preset included angle ranges from 3° to 20°, and/or the second preset included angle ranges from -3° to -20°.

8. The acoustic filter according to any one of claims 1 to 7, wherein an edge that is of the first electrode finger and that is located in the slant region comprises a straight line segment, and/or an edge that is of the first electrode finger and that is located in the slant region comprises an arc line segment.

9. The acoustic filter according to any one of claims 1 to 8, further comprising a load portion, wherein the load portion is located in the slant region, and is located on a side that is of the first electrode finger and that is away from the piezoelectric substrate.

10. The acoustic filter according to claim 9, wherein the load portion comprises a conducting layer, and an orthographic projection of the conducting layer on the piezoelectric substrate is located within an orthographic projection of the first electrode finger on the piezoelectric substrate.

11. The acoustic filter according to claim 9, wherein the load portion comprises a dielectric layer, the dielectric layer is parallel to the second direction, and at least a part that is of the first electrode finger and that is located in the slant region overlaps the dielectric layer.

12. The acoustic filter according to any one of claims 1 to 11, wherein each of the first bus bar and the second bus bar comprises a first convergence region, a grid region, and a second convergence region that are arranged in the first direction, and the grid region is located between the first convergence region and the second convergence region; and
a part that is of the bus bar and that is located in the grid region comprises a plurality of grids disposed at intervals in the second direction.

13. The acoustic filter according to claim 12, wherein center lines of the grids of the first bus bar are first center lines, center lines of the grids of the second bus bar are second center lines, and the first center lines and the second center lines all extend in the first direction;
a center line of a part that is of a first electrode finger or a second electrode finger bordering the first bus bar and that is located in the edge region coincides with one first center line; and
a center line of a part that is of a first electrode finger or a second electrode finger bordering the second bus bar and that is located in the edge region coincides with one second center line.

14. The acoustic filter according to claim 12, wherein center lines of the grids of the first bus bar are first center lines, center lines of the grids of the second bus bar are second center lines, and the first center lines and the second center lines all extend in the first direction; and
a first electrode finger and a second electrode finger that are adjacent in the second direction are located on two sides of one first center line, and a distance between the first electrode finger and the center line is equal to a distance between the second electrode finger and the center line.

15. The acoustic filter according to claim 13 or 14, wherein the grids of the first bus bar and the grids of the second bus bar are symmetrically disposed.

16. The acoustic filter according to claim 13 or 14, wherein the grids of the first bus bar and the grids of the second bus bar are disposed in a staggered manner in the first direction.

17. A production method for an acoustic filter, comprising:
providing a piezoelectric substrate; and
forming an interdigital transducer, wherein the interdigital transducer is located on a side of the piezoelectric substrate, wherein
the interdigital transducer comprises a first bus bar and a second bus bar, and the first bus bar and the second bus bar are disposed opposite to each other in a first direction;
the interdigital transducer further comprises an interdigital electrode, and the interdigital electrode comprises a plurality of first electrode fingers and a plurality of second electrode fingers; the first electrode finger and the second electrode finger are oppositely disposed at an interval in the first direction, one of the first electrode finger and the second electrode finger is connected to the first bus bar, and the other is connected to the second bus bar; and the first electrode fingers and the second electrode fingers are alternately disposed at intervals in a second direction;
an edge region, a gap region, a central region, and a slant region that are arranged in the first direction are comprised between the first bus bar and the second bus bar, the slant region is located between the central region and the gap region, and the gap region is located between the slant region and the edge region;
the second electrode fingers are located in the edge region, and are parallel to the first direction;
parts that are of the first electrode finger and that are located in the edge region, the gap region, and the central region are parallel to the first direction, and a part that is of the first electrode finger and that is located in the slant region is slanted relative to both the first direction and the second direction; and in any one of the first electrode finger and the second electrode finger that are oppositely disposed at an interval in the first direction, the part that is of the first electrode finger and that is located in the central region is located on a first side of the opposite second electrode finger; and
both the first direction and the second direction are parallel to the piezoelectric substrate, and the first direction is perpendicular to the second direction.

18. An electronic device, comprising the acoustic filter according to any one of claims 1 to 16.
